# FASCICULE DE BREVET EUROPEEN

(11) **EP 3 375 096 B1**
(45) Date de publication et mention de la délivrance du brevet: **31.01.2024**
(21) Numéro de dépôt: 16804839.5
(22) Date de dépôt: 10.11.2016
(51) Int. Cl.: H03M 1/16

(54) **CONVERTISSEUR ANALOGIQUE-NUMERIQUE A APPROXIMATIONS SUCCESSIVES**
ANALOG-DIGITAL-WANDLER MIT AUFEINANDERFOLGENDEN ANNÄHERUNGEN
ANALOG-TO-DIGITAL CONVERTER WITH SUCCESSIVE APPROXIMATIONS

(30) Priorité: 13.11.2015 FR 1560873
(43) Date de publication de la demande: 19.09.2018
(73) Titulaire: LYNRED, 91120 Palaiseau (FR)
(72) Inventeur: DECAENS, Gilbert, 38000 Grenoble (FR)
(74) Mandataire: Talbot, Alexandre
(86) Numéro de dépôt international: PCT/FR2016/052929
(87) Numéro de publication internationale: WO 2017/081423

(56) Documents cités:
- US-A1- 2010 085 229
- US-B2- 8 344 926
- MIN GYU KIM ET AL: "A 10 MS/s 11-bit 0.19 mm Algorithmic ADC With Improved Clocking Scheme", IEEE JOURNAL OF SOLID-STATE CIRCUITS, IEEE SERVICE CENTER, PISCATAWAY, NJ, USA, vol. 44, no. 9, 1 septembre 2009 (2009-09-01), pages 2348-2355, XP011275838, ISSN: 0018-9200, DOI: 10.1109/JSSC.2009.2023158
- NAGARAJ K: "EFFICIENT CIRCUIT CONFIGURATIONS FOR ALGORITHMIC ANALOG TO DIGITAL CONVERTERS", IEEE TRANSACTIONS ON CIRCUITS AND SYSTEMS II: ANALOG AND DIGITALSIGNAL PROCESSING, INSTITUTE OF ELECTRICAL AND ELECTRONICS ENGINEERS INC, 345 EAST 47 STREET, NEW YORK, N.Y. 10017, USA, vol. 40, no. 12, 1 décembre 1993 (1993-12-01), pages 777-785, XP000426681, ISSN: 1057-7130, DOI: 10.1109/82.260242
- HSU LIANG HO ET AL: "SWITCHED CAPACITOR CIRCUITS IN THE IMPLEMENTATION OF MULTIPLE-VALUED LOGIC", PROCEEDINGS OF THE INTERNATIONAL SYMPOSIUM ON MULTIPLE VALUED LOGIC. GUANGZHOU, CHINA, MAY 29 - 31, 1989; [PROCEEDINGS OF THE INTERNATIONAL SYMPOSIUM ON MULTIPLE VALUED LOGIC], WASHINGTON, IEEE COMP. SOC. PRESS, US, vol. SYMP. 19, 29 mai 1989 (1989-05-29), pages 202-209, XP000169662, ISBN: 978-0-8186-1947-2
- MASANORI FURUTA ET AL: "A 10-bit, 40-MS/s, 1.21 mW Pipelined SAR ADC Using Single-Ended 1.5-bit/cycle Conversion Technique", IEEE JOURNAL OF SOLID-STATE CIRCUITS., vol. 46, no. 6, 1 juin 2011 (2011-06-01), pages 1360-1370, XP055346925, PISCATAWAY, NJ, USA ISSN: 0018-9200, DOI: 10.1109/JSSC.2011.2126390
- JIN-FU LIN ET AL: "Low-Power and Wide-Bandwidth Cyclic ADC With Capacitor and Opamp Reuse Techniques for CMOS Image Sensor Application", IEEE SENSORS JOURNAL, IEEE SERVICE CENTER, NEW YORK, NY, US, vol. 9, no. 12, 1 December 2009 (2009-12-01), pages 2044-2054, XP011279343, ISSN: 1530-437X, DOI: 10.1109/JSEN.2009.2033198

## Description

### Domaine technique de l'invention

L'invention est relative à un convertisseur analogique-numérique à approximations successives.

### État de la technique

La conversion d'un signal analogique en un signal numérique est réalisée de manière conventionnelle au moyen de convertisseurs analogique-numérique. Plusieurs types de convertisseurs analogique-numérique sont connus et leurs utilisations sont définies en fonction de leur temps de conversion, de leur précision et en fonction de leur coût de fabrication qui tient compte des difficultés de réalisation et/ou de la surface utilisée sur une puce et/ou de la consommation. Les convertisseurs se répartissent en différentes catégories, les plus connus sont les convertisseurs flash, les convertisseurs « pipeline », les convertisseurs à approximations successives, les convertisseurs « rampe » et les convertisseurs « Sigma-Delta ».

Les convertisseurs à approximations successives sont des systèmes bouclés qui sont construits autour d'un seul étage constitué par un convertisseur à un bit. La conversion de la tension à convertir Vin est réalisée bit par bit à chaque nouvelle itération, c'est-à-dire au moyen de cycles d'horloges successifs, en partant du bit de poids le plus fort (« Most Significant Bit » en anglais ») jusqu'au bit de poids le plus faible (« Lowest Significant Bit »). Ainsi, pour convertir une tension Vin sur n bits, il faut au minimum n itérations. Il apparaît alors de manière évidente que plus la résolution numérique recherchée est importante, plus le nombre de bits de conversion nécessaires est élevé et plus le temps de conversion est important.

Le fonctionnement d'un tel convertisseur cyclique peut être expliqué de la manière suivante. La tension à convertir Vin est comprise dans une gamme de tensions prédéfinies, délimitée par des première et seconde tensions. Cette gamme de tension est divisée en deux sous-gammes égales, une première sous-gamme comportant les tensions les plus basses et la deuxième sous-gamme comportant les tensions les plus hautes. La délimitation de ces sous-gammes est réalisée au moyen d'une tension de comparaison Vref. On cherche ensuite à connaître dans quelle sous-gamme se situe la tension Vin. Selon que la tension à convertir se situe dans la sous-gamme des valeurs basses ou des valeurs hautes de la gamme de départ, on affecte respectivement un « 0 » ou un « 1 » au bit le plus élevé représentatif de la comparaison à la tension de comparaison Vref. La sous-gamme comportant la tension Vin est alors de nouveau divisée en deux parties égales et on recherche de nouveau à quelle partie appartient la tension à convertir et un second bit égal à 1 ou à 0 est défini à partir de cette nouvelle comparaison et ainsi de suite selon la résolution recherchée.

Deux approches sont envisageables pour réaliser cette conversion. Dans une première approche, une tension de référence est soustraite de la tension représentative de la tension à convertir. Selon que le bit calculé est égal à 1 ou 0, la valeur de la tension de référence est égale à la tension de comparaison ou est nulle de manière à représenter lors de l'itération suivante la nouvelle gamme accessible, c'est-à-dire la sous-gamme de l'itération précédente qui comprenait la tension à convertir.

Dans une seconde approche, qui est équivalente du point de vue du résultat de la conversion, les tensions définissant les gammes accessibles sont fixes et c'est la tension à convertir Vin (qui est multipliée par deux), à laquelle on a soustrait une valeur de référence pour définir la tension intermédiaire.

La valeur de la tension de référence est égale à une des bornes de la gamme de tension accessible en fonction de la valeur du bit pour définir la tension intermédiaire.

Selon que la tension à convertir se situe dans l'une ou l'autre des sous-gammes, une tension intermédiaire Vi représentative de la tension à convertir est calculée à partir de la tension à convertir et de la tension de référence. Cette tension intermédiaire Vi est la tension à convertir de l'itération suivante ou du bloc suivant, c'est-à-dire la tension utilisée pour la détermination du bit suivant.

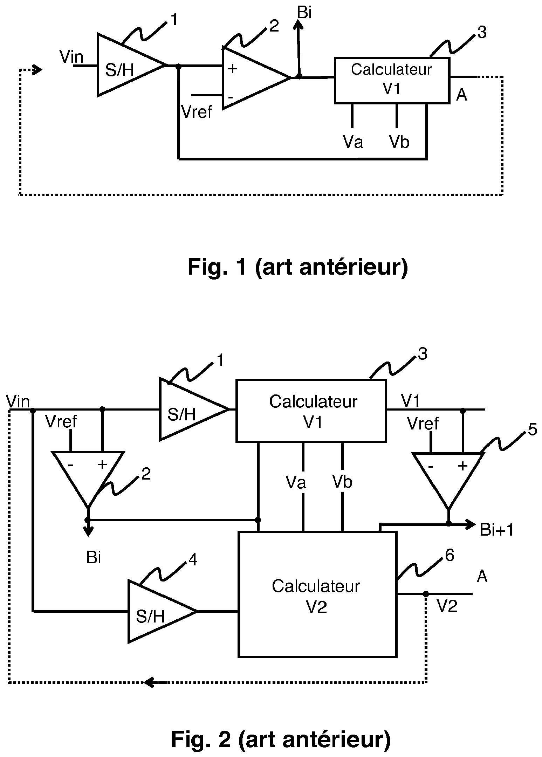

Un exemple typique de convertisseur à approximations successives est un convertisseur de type cyclique ou algorithmique illustré à la figure 1.

Dans un convertisseur cyclique, la tension à convertir Vin est comparée successivement à une fraction binaire d'une tension de comparaison Vref qui est de plus en plus précise au fur et à mesure des coups d'horloge successifs. La tension à convertir Vin et l'ensemble des tensions intermédiaires Vi sont comparées à la référence de comparaison, la tension Vref.

La tension à convertir Vin est appliquée à une entrée d'un premier échantillonneur/bloqueur 1 (« Sample And Hold » en anglais). La borne de sortie du premier échantillonneur-bloqueur 1 est connectée à une première entrée d'un premier comparateur 2 à sortie numérique sur un bit. La tension de comparaison Vref est appliquée sur la seconde entrée du comparateur 2 à sortie numérique. La borne de sortie du comparateur 2 délivre alors un bit *Bi* représentatif de la comparaison entre les tensions appliquées à ses deux bornes d'entrée. La borne de sortie du comparateur 2 est connectée à un registre qui sauvegarde le bit *Bi* délivré. La borne de sortie du comparateur est également connectée à une borne d'entrée d'un moyen 3 de calcul d'une première tension intermédiaire V1, tel qu'un calculateur d'une première tension intermédiaire V1. La première tension intermédiaire V1 est représentative de la tension 2Vin-(Va+Vb)/2+*Bi*.(Va-Vb)/2+*B̅i* .(Vb-Va)/2 selon l'approche utilisée pour la gestion des tensions lors des itérations comme expliqué précédemment. Selon la valeur du bit *Bi,* le calculateur 3 délivre en sortie une tension V1 représentative de 2Vin-Vb ou 2Vin-Va qui correspond au résidu de type analogique qui est appliqué à l'entrée du prochain étage de convertisseur utilisé pour convertir la tension Vin sur un deuxième bit. La borne de sortie du calculateur 3 peut alors être connectée à l'entrée de ce même étage (figure 1) ou alors à l'entrée de l'étage suivant (typiquement dans une architecture pipeline non représentée).

Ainsi, au moyen de cette architecture, la tension à convertir Vin est appliquée à l'entrée du premier échantillonneur-bloqueur 1 qui la stocke en mémoire pendant toute l'itération. En sortie du premier échantillonneur-bloqueur 1, la tension Vin est comparée à la tension de comparaison Vref par le premier comparateur numérique 2 qui délivre en sortie un bit *Bi* représentatif de la comparaison. Par convention, si la tension Vin est supérieure à la tension Vref, le premier comparateur 2 renvoie un « 1 », dans le cas contraire, il renvoie un « 0 ». Ce bit *Bi* représentatif est enregistré dans un registre (non représenté), et est également appliqué au calculateur 3 de la première tension intermédiaire V1. Ainsi, à chaque itération, le même convertisseur détermine un bit représentatif de la tension à convertir Vin bien que cette tension ne soit pas réellement appliquée au convertisseur pendant toute la durée de la conversion. En effet, lors de la seconde itération et des itérations suivantes, la conversion est réalisée sur la première tension intermédiaire V1 qui est représentative de la tension à convertir et des tensions intermédiaires suivantes représentatives des tensions intermédiaires précédentes.

Un exemple de réalisation est décrit dans la publication de Ogawa et al. « A High Speed Switched-Capacitor Analog-to-Digital Converter Using Unity-Gain Buffers » IEICE transactions on Fundamentals of Electronics, Communications and Computer Sciences, Engineering Sciences Society Vol/ 76A, n°6, 1993, pp924-930. Dans ce mode de réalisation, deux comparateurs sont mis en série et sont agencés de manière à utiliser les deux phases d'un coup d'horloge pour générer successivement les deux bits à partir de la tension à convertir et de la tension intermédiaire.

D'une manière générale, les convertisseurs à approximations successives sont limités à une résolution sur 10 bits car les imprécisions sur les différentes tensions dégradent la précision du résultat numérique final et une conversion sur plus de 16 bits n'apporte pas plus de précision qu'une conversion sur 10 bits à cause des erreurs successives introduites à chaque itération.

Une solution à ce problème est proposée dans le document US 8,344,926 où le convertisseur réalise la multiplication du signal par un facteur 2 et par un facteur 4 afin de réaliser la conversion sur 2 bits dans un même étage. La solution proposée est performante mais elle entraine une complexité plus importante.

Le document US 2010/0085229 décrit un convertisseur analogique-numérique algorithmique. Le nombre d'amplificateurs de prétraitement dans le convertisseur flash est réduit en mutualisant ces derniers. Le circuit possède également deux convertisseurs numérique-analogique distincts reliés à un soustracteur et à un amplificateur opérationnel.

L'article "Low-Power and Wide-Bandwidth Cyclic ADC With Capacitor and Opamp Reuse Techniques for CMOS Image Sensor Application" de JIN-FU LIN ET AL, DOI : 10.1109/JSEN.2009.2033198 CiteNPL, présente un convertisseur analogique-numérique cyclique utilisant des techniques de réutilisation de condensateurs et d'amplificateurs pour réduire la consommation d'énergie et la surface de silicium occupée.

### Objet de l'invention

L'invention a pour objet la réalisation d'un convertisseur qui soit plus facile à mettre en oeuvre tout en garantissant une plus grande précision dans la conversion numérique sur n bits d'une tension analogique, et qui autorise une surface de convertisseur réduite pour être utilisé dans des systèmes embarqués.

On tend à atteindre un tel résultat au moyen d'un convertisseur selon la revendication 1 et notamment un convertisseur comportant :
- une borne d'entrée d'un étage sur laquelle est appliquée une tension à convertir, la tension à convertir étant comprise dans une gamme de conversion délimitée par des première et seconde tensions,
- un premier comparateur de la tension à convertir à au moins une première tension de comparaison, ledit premier comparateur délivrant, sur une première sortie numérique, une première valeur numérique sur au moins un premier bit représentatif de ladite comparaison,
- un premier calculateur délivrant une première tension intermédiaire fonction de la tension à convertir, du premier résultat numérique et desdites première et seconde tensions,
- un second comparateur de la première tension intermédiaire à au moins une seconde tension de comparaison, ledit second comparateur délivrant, sur une seconde sortie numérique, une seconde valeur numérique sur au moins un second bit représentatif de ladite comparaison,
- un second calculateur d'une deuxième tension intermédiaire délivrant sur une sortie analogique du convertisseur ladite deuxième tension intermédiaire à partir de la tension à convertir, des premier et second résultats numériques et desdites première et seconde tensions, le second calculateur étant relié à la borne d'entrée pour recevoir la tension à convertir.

Le convertisseur analogique-numérique est remarquable en ce que le premier calculateur et le deuxième calculateur sont formés par un même calculateur comportant un amplificateur, la sortie de l'amplificateur délivrant la première tension intermédiaire et la deuxième tension intermédiaire.

L'invention a pour objet un procédé de fonctionnement selon la revendication 11 et notamment un procédé de fonctionnement d'un convertisseur analogique-numérique qui comporte les étapes successives suivantes :
- fournir un convertisseur tel que présenté précédemment,
- échantillonner la tension à convertir durant une première période,
- comparer la tension à convertir à une première tension de comparaison au moyen du premier comparateur,
- calculer la première tension intermédiaire au moyen du calculateur durant une deuxième période,
- comparer la première tension intermédiaire à une deuxième tension de comparaison au moyen du deuxième comparateur,
- calculer une deuxième tension intermédiaire au moyen du calculateur durant une troisième période.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
- la figure 1 représente, de manière schématique, un convertisseur cyclique à un bit, selon l'art antérieur,
- la figure 2 représente, de manière schématique, un convertisseur à approximations successives à deux bits selon l'art antérieur,
- les figures 3 et 4 représentent, deux modes de réalisation particuliers d'un convertisseur à deux bits selon l'invention,
- les figures 5, 6 et 7 représentent, de manière schématique, différentes étapes de fonctionnement d'un convertisseur à approximations successives à deux bits, selon l'invention,
- la figure 8 représente, de manière schématique, un chronogramme d'activation des différents interrupteurs et comparateurs d'un convertisseur à approximations successives, selon l'invention,
- la figure 9 représente, une variante de réalisation particulière d'un convertisseur représenté à la figure 4,
- les figures 10 et 11 représentent, des variantes de réalisation particulières d'un convertisseur représenté à la figure 4,
- la figure 12 représente un mode de réalisation particulier d'un convertisseur sur 3 bits selon l'invention,
- la figure 13, de manière schématique, un chronogramme d'activation des différents interrupteurs et comparateurs d'un convertisseur à approximations successives, selon l'invention pour un convertisseur sur 3 bits.

### Description d'un mode de réalisation préférentiel de l'invention

Comme illustré aux figures 2, 3, 4, 9, 10, 11 et 12, le convertisseur analogique-numérique à approximations successives sur au moins deux bits est composé d'au moins un premier étage comportant un convertisseur analogique-numérique sur au moins deux bits *Bi* et *B*_{*i*+1}. Ce premier étage comporte une borne d'entrée sur laquelle la tension à convertir Vin est appliquée. Le premier étage comporte avantageusement deux bornes de sortie numérique associées aux bits *Bi* et *B*_{*i*+1} et une borne de sortie analogique A qui peut être associée avec un autre étage ou rebouclée sur l'entrée de ce premier étage. D'une manière générale, le convertisseur est composé d'au moins un premier étage que ce soit pour une intégration dans une architecture de type pipeline ou cyclique. Dans le cas d'une architecture cyclique, il est avantageux de placer un module échantillonneur-bloqueur entre la sortie et l'entrée du convertisseur. Il est également avantageux de réaliser un convertisseur cyclique en utilisant deux étages installés tête-bêche. Pour délivrer n bits, le convertisseur présente avantageusement n bornes de sortie numérique ou moins de n bornes.

Dans une architecture de type pipeline, la borne de sortie analogique A de l'étage représenté à la figure 2 est connectée à une entrée d'un convertisseur de même type formant l'étage suivant (non représenté). De cette manière, le premier étage convertit les deux premiers bits de la tension à convertir Vin et fournit à l'étage suivant un résidu analogique, c'est-à-dire une tension résiduelle V2, qui est convertie pour former les deux bits suivants. Il y a alors, dans cet exemple, une conversion de la tension Vin sur au moins quatre bits.

Dans une architecture dite cyclique représentée aux figures 2, 4 et 9, il n'y a qu'un seul étage de convertisseur analogique-numérique, le premier étage et avantageusement un module échantillonneur-bloqueur. La borne de sortie analogique A est alors reconnectée à la borne d'entrée du premier et unique étage. De cette manière, à chaque itération, le convertisseur convertit deux bits de la tension à convertir Vin. A la première itération, le convertisseur délivre les premier et second bits à partir de la tension à convertir Vin. Lors du second cycle d'horloge ou de l'itération suivante, le convertisseur délivre les troisième et quatrième bits à partir du résidu analogique, c'est-à-dire la tension V2 délivrée au cycle précédent. La reconnexion entre la borne de sortie analogique A et la borne d'entrée est réalisée de manière conventionnelle.

D'une manière générale, on peut obtenir un convertisseur analogique-numérique sur 2n bits en additionnant n étages successifs de convertisseurs sur deux bits (architecture de type pipeline) ou en réalisant au moins n boucles de conversion sur deux bits sur le premier étage (convertisseur cyclique) ou sur deux étages tête-bêche. Le convertisseur sur 2 bits peut être remplacé par un convertisseur délivrant plus de 2 bits.

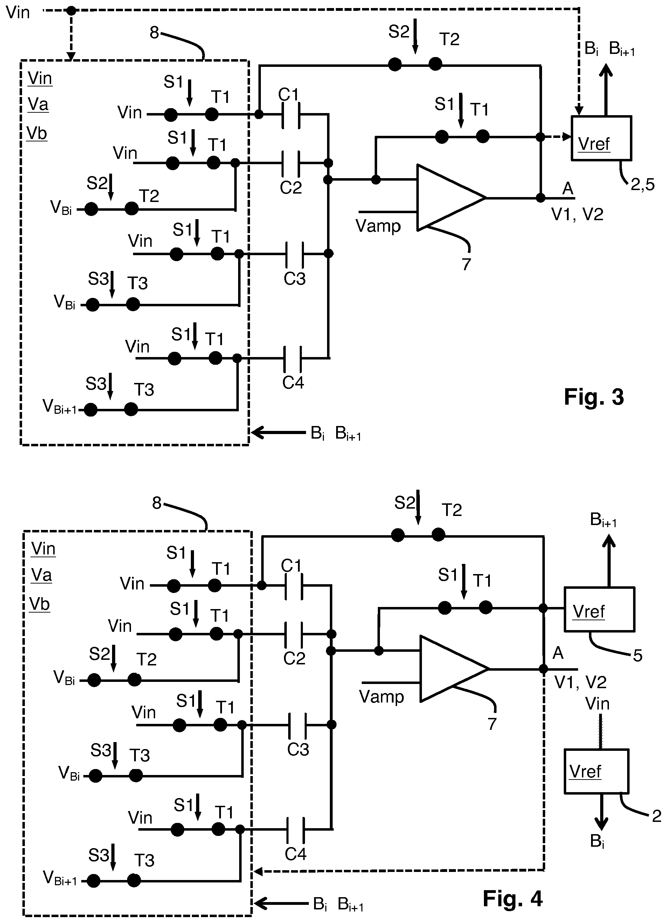

De manière conventionnelle, la tension à convertir Vin est comprise entre des première Va et seconde Vb tensions qui représentent les limites de la gamme accessible à la tension Vin. La seconde tension Vb est supérieure à la première tension Va. Selon les différents modes de réalisation possibles, la gamme accessible est divisée en au moins deux portions qui sont délimitées par au moins une première tension de comparaison Vref. Si la gamme accessible comporte un nombre pair de sous-gammes, la gamme est divisée en des sous-gammes égales. Si la gamme accessible comporte un nombre impair de sous-gammes, l'étendue des différentes sous-gammes peut être variable. Avantageusement, la gamme accessible est divisée en deux ou trois sous-gammes. Dans le cas particulier où la gamme est divisée en deux portions égales, la délimitation est réalisée par une seule tension de comparaison Vref qui est égale à (Va+Vb)/2. Les figures 3 et 4 représentent un découpage de la gamme de tension en deux sous-gammes.

A titre d'exemple, si les première et seconde tensions sont égales en valeur absolues, mais opposées en signes (Va = -Vb), alors la tension de comparaison est nulle (Vref = 0). Si les première et seconde tensions sont respectivement égales à 0 et V (Va = 0, Vb = V), alors la tension de comparaison Vref est égale à V/2. La tension de comparaison est disposée à équipotentielle des tensions Va et Vb.

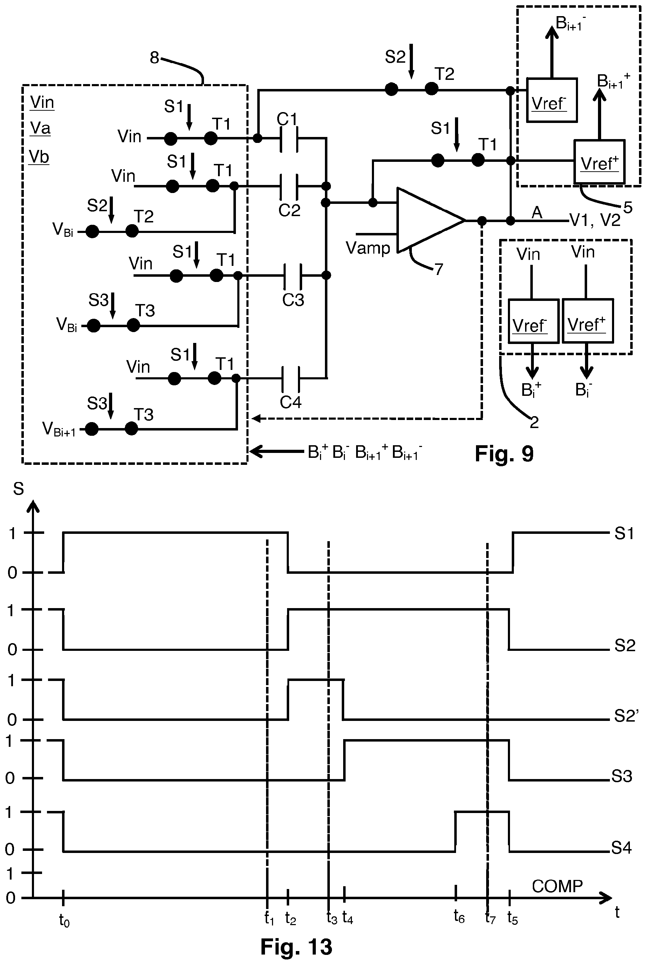

Il est également possible de diviser la gamme en plus de deux portions, typiquement trois portions, afin d'éviter les erreurs des moyens de comparaison. Dans ce mode de réalisation, illustré à la figure 9 la tension à convertir Vin est comparée à plusieurs tensions de comparaison, par exemple des première et seconde tensions de comparaison élémentaires Vref⁻ et Vref⁺. Un exemple de mise en oeuvre de ce procédé de comparaison est décrit par exemple par Ginetti et al « A CMOS 13-b Cyclic RSD A/D Converter » IEEE Journal of Solid-State Circuits Vol.27, N°7, July 1992.

De manière classique, le convertisseur peut faire évoluer la tension à convertir Vin entre deux itérations ou alors il peut faire évoluer les tensions délimitant la gamme accessible et la tension de comparaison Vref. De ce fait dans un mode de réalisation, la tension à convertir Vin est multipliée, par exemple, par un facteur deux ou par un facteur quatre alors que dans un autre mode de réalisation, la gamme accessible est divisée par deux ou par quatre en modifiant les tensions limites.

Comme précisé précédemment, selon le mode de réalisation utilisé, les première et seconde tensions Va et Vb peuvent être identiques entre les différents étages et au sein d'un étage, mais ces tensions peuvent également évoluer entre les différents étages et au sein des étages afin de représenter les gammes de tensions accessibles à la tension à convertir ou à sa tension représentative qui va être convertie.

Comme illustré à la figure 2, le premier étage du convertisseur comporte de manière schématique, un premier moyen 2 de comparaison à sortie numérique, par exemple un premier comparateur à sortie numérique, de la tension à convertir Vin à au moins la première tension de comparaison Vref1 représentative de la division de la gamme de tensions accessible en au moins deux sous-gammes.

Ce premier comparateur 2 à sortie numérique délivre, sur la première borne de sortie numérique du premier étage, une première valeur numérique, sur au moins un premier bit *Bi,* qui est représentative de la comparaison entre la tension à convertir Vin et la ou les tensions de comparaison. A titre d'exemple, si la gamme est divisée en deux sous-gammes, le premier comparateur 2 délivre un premier bit et si la gamme est divisée en trois sous-gammes, le premier moyen de comparaison délivre deux bits.

Le premier étage comporte également un premier moyen 3 de calcul, tel qu'un premier calculateur, délivrant une première tension intermédiaire V1. Cette première tension intermédiaire V1 est fonction de la tension à convertir Vin, de la valeur du premier résultat numérique (au moins le premier bit *Bi*) et des première Va et seconde Vb tensions. De cette manière, le premier moyen 3 de calcul est connecté directement à la tension Vin et délivre en sortie la tension intermédiaire V1 provenant de la tension Vin des première et seconde tensions Va et Vb et de la valeur du premier bit *Bi.*

Le premier moyen 3 de calcul est un moyen de calcul direct car la tension délivrée en sortie provient directement de la valeur de la tension à convertir Vin. Comme dans l'art antérieur, un échantillonneur-bloqueur peut être utilisé pour fournir la tension Vin au convertisseur ou à certains éléments du convertisseur. L'échantillonneur-bloqueur permet de réaliser l'échantillonnage de la tension Vin et donc de délivrer une tension constante à l'entrée du moyen de calcul 3.

Par convention, la tension à convertir Vin est située dans une première gamme de tensions qui est délimitée par les première et seconde tensions et la première tension intermédiaire V1 est située dans une seconde gamme de tensions. Cette seconde gamme de tensions est représentative de la sous-gamme de la première gamme de tensions qui comportait la tension à convertir Vin. Ainsi chaque tension intermédiaire est située dans une gamme dédiée.

Un second moyen 5 de comparaison avec une sortie numérique sur au moins un bit est également intégré dans le premier étage. Ce second moyen 5 de comparaison numérique, tel qu'un second comparateur à sortie numérique, compare la première tension intermédiaire V1 à au moins une seconde tension représentative de la division de la seconde gamme en au moins deux sous-gammes.

Comme pour la première gamme, la seconde gamme peut être divisée par un nombre pair ou impair de sous-gammes. La seconde gamme peut être divisée par un nombre pair de sous-gammes égales ou alors par un nombre impair de sous-gammes ayant une étendue variable. Dans le cas d'une gamme divisée en deux sous-gammes délimitée par la tension de comparaison, le second moyen 5 de comparaison numérique compare la première tension intermédiaire V1 à la tension de comparaison Vref2.

Le second comparateur 5 à sortie numérique délivre en sortie une seconde valeur numérique, au moins un second bit *B*_{*i*+1} sur la seconde borne de sortie numérique du premier étage. Cette seconde valeur numérique est représentative de la comparaison entre la première tension intermédiaire V1 et la ou les tensions de comparaison.

Dans le cas d'une division de chaque gamme en deux sous-gammes, la tension de comparaison qui est comparée à la tension intermédiaire V1 peut être identique, ou différente, en valeur à la tension qui a été utilisée comme référence pour la comparaison de la tension à convertir Vin. La valeur de la tension de comparaison Vref2 entre ces deux étapes de comparaison dépend du mode de gestion des tensions entre les différentes sous-gammes comme cela a été expliqué précédemment. Il en va de même des multiples tensions de comparaisons utilisées par chaque comparateur lorsque la gamme est divisée en plus de deux sous-gammes.

Un second moyen 6 de calcul, tel qu'un second calculateur, d'une tension résiduelle V2 est utilisé et délivre la tension résiduelle V2 sur la sortie analogique A du premier étage. La tension résiduelle V2 est fonction de la tension à convertir Vin, des valeurs des premier et second résultats numériques et des première et seconde tensions Va et Vb. Dans le cas d'un convertisseur sur 2 bits, la tension V2 est appelée tension résiduelle. Dans le cas d'un convertisseur sur plus de 2 bits, la tension V2 est appelée deuxième tension intermédiaire.

Le second moyen 6 de calcul est également un moyen de calcul direct car la valeur de la tension résiduelle V2 provient directement de la tension à convertir Vin, des valeurs de première et seconde tensions Va et Vb et des valeurs des premier et second bits. La tension résiduelle V2 est obtenue directement à partir de la tension Vin et non à partir de la tension intermédiaire V1. Bien que la tension intermédiaire provienne de la tension Vin, la tension Vin est modifiée et donc détériorée pour obtenir la tension intermédiaire. Ne pas utiliser la tension V1 de manière analogique permet de diminuer l'altération du signal à convertir pour déterminer les bits.

La tension résiduelle V2 obtenue à partir du second moyen 6 de calcul est donc moins sensible aux erreurs de conversions. La tension à convertir Vin est appliquée directement à l'entrée du second moyen 6 de calcul. La sortie analogique du second moyen de calcul est réappliquée sur son entrée ou sur l'entrée de l'étage suivant. Dans le cas d'une architecture cyclique, la sortie analogique du second moyen 6 de calcul est appliquée à l'entrée du même second moyen 6 de calcul. Un échantillonneur-bloqueur est avantageusement utilisé pour un convertisseur cyclique. Il est également avantageux d'utiliser deux étages tête-bêche.

De manière particulièrement avantageuse illustrée aux figures 3 à 6, le premier calculateur 3 et le second calculateur 6 sont formés par le même amplificateur 7 ce qui permet un gain en compacité important. Le premier calculateur 3 et le deuxième calculateur 6 sont formés par des éléments communs, par exemple un amplificateur au moins deux interrupteurs et une source de tension qui sont mutualisés. De préférence, au moins deux condensateurs sont également mutualisés pour délivrer les tensions V1 et V2.

Utiliser le même calculateur pour calculer la tension intermédiaire V1 et la tension résiduelle V2 permet de réaliser une seule période d'échantillonnage. Une telle architecture est donc avantageuse car elle permet de charger tous les condensateurs durant la même période ce qui réduit les contraintes dans toute la chaine de traitement de l'information depuis l'acquisition de la donnée analogique jusqu'au traitement final de l'information numérique.

Dans un mode de réalisation encore plus avantageux illustré à la figure 3, cette architecture permet également de gagner en compacité en utilisant le même comparateur pour former le premier comparateur 2 et le deuxième comparateur 5. En d'autres termes, un seul comparateur peut former le premier comparateur 3 et le deuxième comparateur 5. Il est alors avantageux de prévoir un commutateur qui soit configuré pour connecter la borne d'entrée du comparateur 2, 5 à la borne de sortie de l'amplificateur 7 ou à la borne d'entrée recevant la tension à convertir Vin afin de comparer la tension à convertir Vin ou la première tension intermédiaire V1.

Dans les modes de réalisation illustrés aux figures 3 à 7 et 9 à 12, la tension à convertir Vin est appliquée directement à l'entrée du calculateur, par l'intermédiaire ou non d'un échantillonneur bloqueur.

L'entrée analogique de l'étage alimente le calculateur. La sortie analogique du calculateur forme la sortie analogique de l'étage ou plus généralement du convertisseur.

Dans des modes de réalisations particuliers qui vont être décrits par la suite, le premier étage peut comporter des éléments supplémentaires afin de permettre un transfert des différentes données, de manière organisée, dans le temps. Pour ce faire, le premier étage va comporter, par exemple, des blocs échantillonneur/bloqueur.

Dans le mode de réalisation illustré à la figure 2 schématisant les fonctionnalités du convertisseur, le premier étage du convertisseur analogique-numérique comporte un premier échantillonneur-bloqueur 1 connecté à la borne d'entrée du premier étage. La tension à convertir Vin est donc appliquée à l'entrée du premier échantillonneur-bloqueur 1. Le premier échantillonneur-bloqueur 1 comporte une entrée de commande, non représentée, qui permet de définir à quel instant la tension imposée à l'entrée du premier échantillonneur-bloqueur 1 doit être échantillonnée. Après échantillonnage, la tension mesurée est ensuite délivrée sur la borne de sortie du premier échantillonneur-bloqueur 1 jusqu'à ce qu'un nouveau signal de commande soit appliqué à la borne de commande. De manière avantageuse, la tension mesurée est délivrée pendant tout le temps de la première phase de l'itération. La tension délivrée par la sortie du premier échantillonneur-bloqueur 1 est égale à la tension à convertir Vin ou très proche, l'échantillonneur-bloqueur n'étant pas parfait. La qualité du résultat final du convertisseur dépend, de manière non négligeable, de la qualité des échantillonneurs-bloqueurs utilisés. Afin de conserver une qualité de conversion élevée cette architecture utilise un faible nombre d'échantillonneurs-bloqueurs comparé au résultat numérique obtenu avec des convertisseurs sur un bit de l'état de l'art.

La tension Vin est connectée à une première borne d'entrée du premier moyen de comparaison 2 à sortie numérique sur un bit qui est ici constitué par un premier comparateur ayant une sortie numérique sur un bit.

La tension de comparaison Vref est appliquée à la deuxième borne d'entrée du premier comparateur 2 qui compare alors la tension de comparaison Vref à la tension à convertir Vin. Selon le résultat de la comparaison entre les tensions à ses bornes, le premier comparateur 2 délivre un premier résultat numérique ou première valeur numérique, par exemple, un premier bit *Bi* qui peut être égal à 1 ou à 0. Par convention, si la gamme est divisée en deux sous-gammes, le bit vaut 1 si la tension est supérieure à la tension de comparaison et il vaut 0 dans les autres cas. Le premier bit *Bi* est égal à 0 ou à 1 par convention, mais en réalité la valeur 1 représente la valeur de l'alimentation du comparateur. Ce premier bit *Bi* correspond au bit de poids le plus fort de la conversion numérique. Ce premier bit est délivré vers l'extérieur par la première borne de sortie numérique du premier étage.

La borne de sortie du premier comparateur 2 à sortie numérique est connectée à un registre (non représenté) qui emmagasine le résultat numérique, typiquement du bit *Bi* (le bit ne pouvant être égale qu'à « 0 » ou à « 1 »). La borne de sortie du premier comparateur 2 est également connectée à l'entrée du calculateur 3 de la première tension intermédiaire V1.

La tension de comparaison Vref est appliquée à une seconde entrée du second comparateur 5. Le second comparateur 5 compare alors la tension de comparaison Vref à la première tension intermédiaire V1 et il délivre en sortie, sur une seconde sortie numérique du convertisseur, le second bit *B*_{*i*+1} de conversion. La valeur du second bit *B*_{*i*+1} est égale à 0 ou 1 selon le résultat de la comparaison ici entre la tension de comparaison Vref et la première tension intermédiaire V1.

Les valeurs du premier bit *Bi* et du deuxième bit *B*_{*i*+1} vont permettre au convertisseur de calculer une tension résiduelle V2 au moyen du deuxième calculateur 6.

Les tensions V1 et V2 sont calculées différemment au moyen du calculateur représenté schématiquement par deux calculateurs différents pour illustrer ses deux fonctionnements différents.

Comme illustré aux figures 3 et 4, le calculateur comporte un amplificateur 7 ayant une première borne d'entrée et une borne de sortie. La borne de sortie de l'amplificateur 7 forme avantageusement la borne de sortie A du convertisseur. L'amplificateur 7 comporte une deuxième borne d'entrée connectée à un générateur d'une tension d'amplification Vamp.

Utiliser un seul calculateur permet de gagner en compacité car l'amplificateur 7 est mutualisé pour calculer la tension V1 et la tension V2.

La première entrée de l'amplificateur 7 est connectée à la sortie de l'amplificateur 7 au moyen d'un premier interrupteur T1. De manière avantageuse, le premier interrupteur T1 connecte directement la première entrée de l'amplificateur 7 avec la sortie de l'amplificateur 7.

La première entrée est également connectée à au moins quatre lignes d'alimentation montées en parallèle également appelées connexions. Chaque ligne d'alimentation comporte un condensateur dont une première borne est reliée à la première entrée de l'amplificateur 7. La deuxième borne de chaque condensateur est reliée à une source de tension 8. Les quatre lignes du convertisseur forment une partie du calculateur et stockent les valeurs de tension échantillonnées.

Les quatre lignes d'alimentation sont nommées respectivement première, deuxième, troisième et quatrième lignes d'alimentation. Les quatre condensateurs sont nommés premier, deuxième, troisième et quatrième condensateurs C1, C2, C3 et C4.

La source de tension 8 est configurée de manière à appliquer une tension spécifique à chacune des lignes d'alimentation dans le temps. Selon les périodes, les tensions peuvent être identiques sur les lignes d'alimentation ou alors différentes. En modulant les tensions appliquées sur les condensateurs, il est possible de réaliser facilement les calculs des tensions V1 et V2.

Un deuxième interrupteur T2 est monté de manière à relier la deuxième borne du premier condensateur C1 à la borne de sortie de l'amplificateur. De manière avantageuse, le deuxième interrupteur T2 connecte directement la deuxième borne du premier condensateur C1 avec la sortie de l'amplificateur 7 pour faciliter les calculs des tensions V1 et V2.

Le deuxième comparateur 5 est connecté à la borne de sortie de l'amplificateur de manière à pouvoir comparer la tension V1 à une référence.

Au moyen des premier et deuxième interrupteurs T1 et T2 et au moyen de la connexion ou de la déconnexion des première, deuxième, troisième et quatrième lignes d'alimentation, l'amplificateur 7 peut calculer la première tension intermédiaire V1 ou la deuxième tension résiduelle V2. En d'autres termes, l'amplificateur 7 associé aux premier et deuxième interrupteurs, aux première et deuxième lignes d'alimentation et à la source de tension 8 forme le premier calculateur 3 apte à calculer la première tension intermédiaire V1.

La source de tension 8 reçoit le résultat du premier comparateur 2 afin de fournir la tension adaptée sur la deuxième ligne d'alimentation et sur la troisième ligne d'alimentation. La source de tension 8 reçoit le résultat du deuxième comparateur 5 afin de fournir la tension adaptée sur la quatrième ligne d'alimentation. Il est alors possible de calculer la tension résiduelle V2.

Dans le mode de réalisation de la figure 3, la tension à convertir Vin est fournie à la source de tension 8 et elle peut être appliquée sur le comparateur 2 pour délivrer le premier bit. La tension à convertir est fournie par tout moyen adapté. Par exemple, l'interrupteur T2 est actionné de manière à ce que la tension Vin appliquée sur le condensateur C1 durant une première période soit mesurée ensuite par le comparateur 2 pour calculer le premier bit. Dans tous les cas, le comparateur est avantageusement configuré de manière à éviter de connecter l'entrée et la sortie de l'amplificateur 7 en même temps. Dans ce mode de réalisation, un seul comparateur peut être utilisé.

Dans le mode de réalisation de la figure 4, la tension à convertir Vin est fournie à un premier comparateur 2 qui délivre le premier bit. La figure 4 illustre également la connexion qui relie la borne de sortie de l'amplificateur 7 à la source de tension 8 pour former un convertisseur cyclique. Cette connexion peut également être utilisée dans le mode de réalisation de la figure 3.

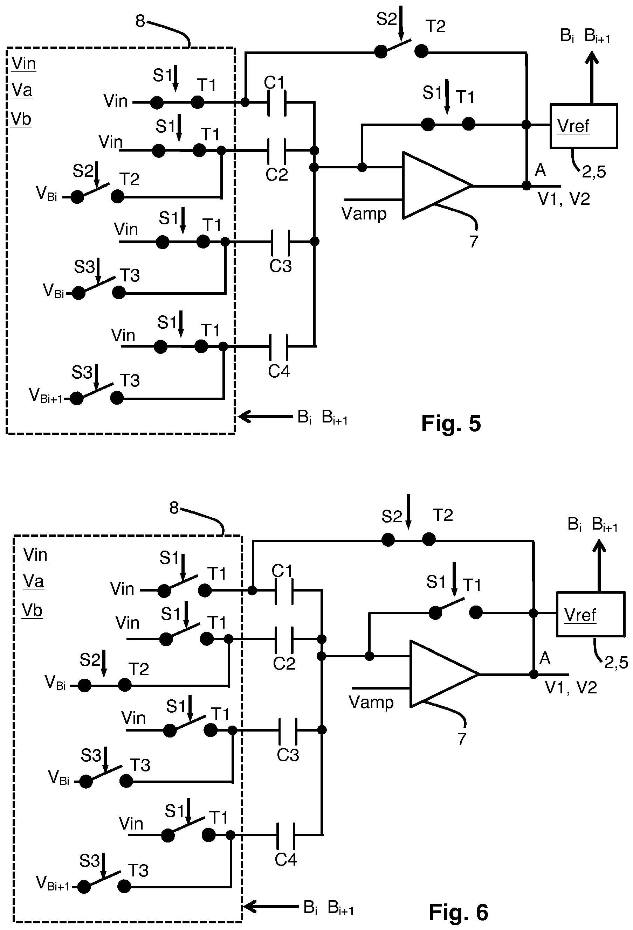

Comme illustré à la figure 5, la source de tension 8 est configurée de manière à appliquer la tension à convertir Vin sur les deuxièmes bornes des premier, deuxième, troisième et quatrième condensateurs durant une première période. Les quatre condensateurs sont chargés en même temps.

Comme illustré à la figure 6, la source de tension 8 est configurée de manière à appliquer une première tension de référence V_{Bi}, par exemple la tension Va ou la tension Vb, sur la deuxième borne du deuxième condensateur C2 durant une deuxième période. Durant cette deuxième période, la source de tension 8 ne fournit aucune tension sur la deuxième borne du premier condensateur C1, sur la deuxième borne du troisième condensateur C3 et sur la deuxième borne du quatrième condensateur C4. Les deuxièmes bornes du troisième condensateur C3 et du quatrième condensateur C4 sont à un potentiel flottant. La deuxième borne du premier condensateur C1 est reliée à la sortie de l'amplificateur 7. Dans le mode particulier illustré à la figure 9, la source de tension 8 est configurée de manière à appliquer une première tension de référence V_{Bi}, par exemple la tension Va, Vb ou (Va+Vb)/2.

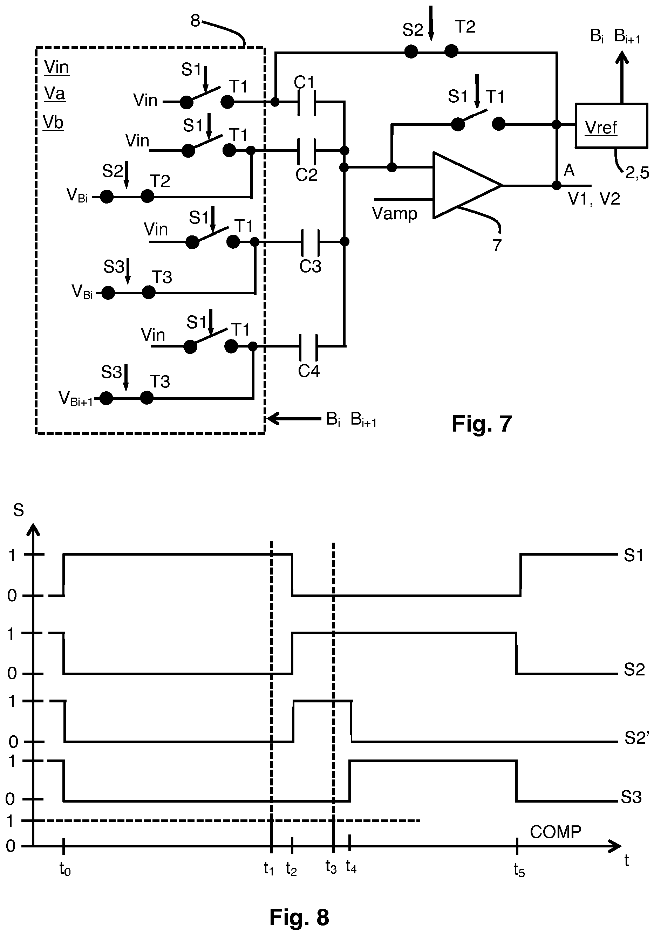

Comme illustré à la figure 7, durant une troisième période, la source de tension 8 est configurée de manière à appliquer la première tension de référence V_{Bi} sur les deuxièmes bornes des deuxième et troisième condensateurs C2 et C3 et une deuxième tension de référence V_{Bi+1}, par exemple la tension Va ou la tension Vb, sur la deuxième borne du quatrième condensateur C4. Durant cette troisième période, la source de tension 8 ne fournit aucune tension sur la deuxième borne du premier condensateur C1. Dans le mode particulier illustré à la figure 9, la source de tension 8 est configurée de manière à appliquer une deuxième tension de référence V_{Bi+1}, par exemple la tension Va, Vb ou (Va+Vb)/2.

Comme indiqué plus haut, de manière classique, la valeur de la première tension de référence V_{Bi} et la valeur de la deuxième tension de référence V_{Bi+1} sont fonctions des première et deuxième valeurs numériques et des tensions Va et Vb. Sur les figures, les valeurs de référence délivrées par la source 8 sont égales aux tensions Va, Vb ou (Va+Vb)/2 mais une autre valeur est également possible.

Le premier interrupteur T1 est à l'état fermé donc passant durant la première période (figure 5). La première borne d'entrée de l'amplificateur 7 est reliée à la borne de sortie de l'amplificateur 7 ce qui permet avantageusement de faire fonctionner l'amplificateur en tant que suiveur. Le deuxième interrupteur T2 est à l'état ouvert durant la première période.

Le deuxième interrupteur T2 est à l'état fermé donc passant durant la deuxième période. La deuxième borne du premier condensateur C1 est reliée électriquement à la borne de sortie de l'amplificateur par l'intermédiaire de l'interrupteur T2 ce qui permet d'appliquer le résultat du calcul entre les condensateurs sur l'entrée du comparateur. Le premier interrupteur T1 est à l'état ouvert donc bloquant durant la deuxième période. Le deuxième interrupteur T2 est à l'état fermé donc passant durant la troisième période (figure 7). Le premier interrupteur T1 est à l'état ouvert donc bloquant durant la troisième période.

La deuxième période est différente de la première période. La deuxième période est postérieure à la première période. Le premier interrupteur T1 n'est pas à l'état fermé en même temps que le deuxième interrupteur T2.

La troisième période est différente de la première période et de la deuxième période. La troisième période est postérieure à la première période et à la deuxième période.

La première période peut être appelée période d'échantillonnage. Durant la première période illustrée à la figure 5, la tension à convertir Vin est appliquée sur les quatre condensateurs C1, C2, C3 et C4 qui vont se charger. L'échantillonnage de la tension à convertir Vin est réalisé en une seule fois sur les quatre condensateurs ce qui est particulièrement avantageux. Les quatre condensateurs sont avantageusement identiques. Durant la première période, le premier interrupteur T1 est à l'état fermé et tous les condensateurs sont soumis aux mêmes conditions de polarisation.

Durant la première période, il est possible de comparer la tension à convertir Vin au moyen du premier comparateur 2. Cet échantillonnage peut être effectué selon le mode de réalisation de la figure 4 où le premier comparateur 2 est dissocié du deuxième comparateur 5. La première valeur numérique est calculée durant la première période.

En variante, il est possible de comparer la tension à convertir Vin au moyen du comparateur formant le premier et le deuxième comparateurs 2 et 5. Par exemple, une connexion électrique directe peut être réalisée entre une des bornes délivrant la tension Vin et le comparateur 2, 5 qui est alors déconnecté de la borne de sortie analogique A. La comparaison est réalisée après la première période et avant la deuxième période ou, en variante, en fin de première période.

Durant la deuxième période illustrée à la figure 6, le deuxième interrupteur T2 est à l'état fermé et la première tension de référence V_{Bi} est appliquée sur le deuxième condensateur C2. Le premier interrupteur T1 est à l'état ouvert. Les troisième et quatrième condensateurs C3 et C4 n'étant pas polarisés, les premier et deuxième condensateurs C1 et C2 forment le premier calculateur 3 qui délivre la tension intermédiaire V1. De manière conventionnelle, la première tension de référence V_{Bi} est fonction de la première valeur numérique, ici de la valeur du premier bit *Bi.*

Le calculateur de la première tension intermédiaire V1 comporte donc une borne d'entrée numérique sur laquelle est appliqué le premier bit *Bi.* Il comporte également des bornes sur lesquelles sont appliquées des tensions représentatives respectivement de la tension à convertir Vin, de la première tension Va et de la seconde tension Vb ou la tension (Va+Vb)/2. Le calculateur de la première tension intermédiaire V1 comporte également une borne de sortie analogique qui délivre la première tension intermédiaire V1. La première tension intermédiaire V1 est calculée au moyen de condensateurs et notamment des condensateurs C1 et C2 qui ont été chargés avec la tension Vin et du condensateur C2 qui reçoit maintenant la tension V_{Bi}.

La première tension intermédiaire V1 est fonction de la tension à convertir Vin, des première Va et seconde Vb tensions et de la valeur du premier bit *Bi.* La première tension intermédiaire V1 est égale ou représentative de la tension 2Vin-(Va+Vb)/2+ *Bi*.(Va-Vb)/2+*B̅i*.(Vb-Va)/2 dans laquelle *B̅i* est égale à 1-Bi. La première tension intermédiaire V1 peut également être écrite sous la forme suivante V1 = 2Vin - *Bi* .Vb - *B̅i*. Va ou une tension représentative de cette formule.

La première tension intermédiaire V1 est délivrée par la sortie de l'amplificateur 7. La tension intermédiaire V1 peut être appliquée directement à l'entrée du deuxième comparateur. En alternative, la première tension intermédiaire V1 peut être appliquée à l'entrée d'un échantillonneur-bloqueur avant d'être appliquée à l'entrée du deuxième comparateur.

La tension V1 est mesurée à un instant prédéterminé sur la borne d'entrée du deuxième comparateur. La tension V1 peut être mesurée par le deuxième comparateur durant la deuxième période. La tension V1 est mesurée avant la troisième période. La deuxième période peut avoir une durée limitée sans que cela impacte le résultat final. Même si la tension V1 n'est pas bien établie, cela n'est pas problématique car la tension V1 est utilisée pour définir un bit et non pour définir de manière analogique la future tension V2 à cet instant. De manière avantageuse, la durée de la deuxième période est inférieure à la durée de la troisième période. De manière particulièrement avantageuse, la durée de la deuxième période est inférieure à la moitié de la durée de la troisième période ce qui permet d'avoir une conversion de bonne qualité dans une période de temps limitée. Le calcul de la tension V1 peut se terminer après la comparaison de la tension V1 avec la tension de comparaison.

Tout comme la valeur du premier bit *Bi,* la valeur du second bit *B*_{*i*+1} est fournie à la source de tension 8 de manière à définir la valeur de la deuxième tension de référence Vref2.

Durant la troisième période illustrée à la figure 7, la deuxième borne du premier condensateur C1 est connectée à la borne de sortie de l'amplificateur 7 par exemple au moyen du deuxième interrupteur T2. La deuxième borne du deuxième condensateur C2 et la deuxième borne du troisième condensateur C3 reçoivent la première tension de référence V_{Bi}. La deuxième borne du quatrième condensateur C4 reçoit la deuxième tension de référence V_{Bi+1} qui peut être la tension Va, la tension Vb ou la tension (Va+Vb)/2.

Cette tension résiduelle V2 qui peut être également assimilée à une seconde tension intermédiaire est fonction de tensions représentatives, avantageusement des multiples, des première Va et seconde Vb tensions, de la tension à convertir Vin et des premier *Bi* et second *B*_{*i*+1} bits. Le calculateur 6 délivre, sur la borne de sortie analogique A du premier étage, la tension résiduelle V2 qui est égale ou représentative de la tension 4Vin -(Va+Vb)+ *Bi*.(Va-Vb)+*B̅i.*(Vb-Va) -(Va+Vb)/2 + *B*_{*i*+1}.(Va-Vb)/2+*B̅*_{*i*+1} (Vb-Va)/2 avec *B̅*_{*i*+1} égale à 1-*B*_{*i*+1}. La tension résiduelle V2 peut également être écrite sous la forme V2 = 4Vin - 2*B̅i*.Va - *2Bi.*Vb - *B*ᵢ₊₁.Vb - *B̅*_{*i*+1}.Va avec *B̅*_{*i*+1} égale à 1-*B*_{*i*+1}.

La deuxième tension intermédiaire V2 est calculée au moyen de condensateurs et notamment des condensateurs C1, C2, C3 et C4 qui ont été chargés avec la tension Vin et des condensateurs C2 et C3 qui reçoivent maintenant la tension V_{Bi} et du condensateur C4 qui reçoit la tension V_{Bi+1}.

Le même amplificateur est utilisé pour réaliser l'étape d'échantillonnage et l'étape de calcul ce qui permet d'éliminer le décalage de tension introduit par l'amplificateur. Cette solution est plus avantageuse que la configuration ou la tension Vamp est appliquée directement sur une des bornes des condensateurs C1, C2, C3 et C4. En effet, dans ce cas de figure, le décalage de tension lié à l'amplificateur est introduit dans le calcul de la tension intermédiaire et dans le calcul de la tension résiduelle ce qui entache d'erreur les calculs à suivre. Dans un mode de réalisation avantageux car très compact et plus précis, l'amplificateur comporte toujours une de ces bornes d'entrée connectée à une des armatures des condensateurs C1, C2, C3 et C4.

La source de tension 8 peut comporter trois bornes d'alimentation qui reçoivent respectivement la tension à convertir Vin et les tensions Va et Vb. Ainsi, en fonction de la période et des valeurs des bits *Bi* et *B*_{*i*+1}, la source de tension est en mesure de fournir la tension adaptée à chaque ligne d'alimentation. Selon les périodes, la source d'alimentation fournit la tension à convertir Vin, la première tension de référence à partir de Va et Vb et la deuxième tension de référence à partir de Va et Vb.

En résumé, la source de tension 8 est configurée pour :
∘ appliquer la tension à convertir Vin sur une deuxième borne des premier, deuxième, troisième et quatrième condensateurs C1, C2, C3 et C4 pendant une première période,
∘ appliquer une première tension de référence V_{Bi} sur la deuxième borne du deuxième condensateur C2 durant une deuxième et une troisième périodes, la première tension de référence V_{Bi} étant représentative de la première valeur numérique *Bi*,
∘ appliquer la première tension de référence V_{Bi} sur la deuxième borne du troisième condensateur C3 durant la troisième période,
∘ appliquer une deuxième tension de référence V_{Bi+1} sur la deuxième borne du quatrième condensateur C4 durant la troisième période, la deuxième tension de référence V_{Bi+1} étant représentative de la deuxième valeur numérique *B*ᵢ₊₁.

Dans un mode de réalisation avantageux, la source de tension 8 comporte une première série d'interrupteurs ou un premier groupe d'interrupteurs reliant un générateur de la tension à convertir Vin aux secondes bornes des premier, deuxième, troisième et quatrième condensateurs, les interrupteurs de la première série ayant une électrode de commande reliée à un générateur d'un premier signal S1. Le générateur de tension peut être la borne d'entrée de l'étage, un échantillonneur-bloqueur qui délivre la tension à convertir ou tout autre élément du circuit apte à délivrer la tension Vin.

Dans un mode de réalisation avantageux, la source de tension 8 comporte une deuxième série d'interrupteurs ou un deuxième groupe d'interrupteurs reliant un générateur de la première tension de référence V_{Bi} à la seconde borne du deuxième condensateur, l'interrupteur ayant une électrode de commande reliée à un générateur d'un deuxième signal S2.

Dans un mode de réalisation avantageux, la source de tension 8 comporte une troisième série d'interrupteurs ou un troisième groupe d'interrupteurs reliant un générateur de la deuxième tension de référence V_{Bi+1} à la seconde borne du quatrième condensateur et reliant un générateur de la première tension de référence V_{Bi} à la seconde borne du troisième condensateur, les interrupteurs de la troisième série ayant une électrode de commande reliée à un générateur d'un troisième signal S3.

Il apparaît que le fonctionnement du calculateur est différent du fonctionnement des convertisseurs de l'art antérieur. Dans les convertisseurs de l'art antérieur, la première tension intermédiaire est calculée et elle est réinjectée dans le deuxième calculateur pour calculer la tension résiduelle V2. Selon l'invention, la tension intermédiaire est calculée une fois à partir des tensions Vin, Va et Vb. La tension résiduelle est ensuite calculée en utilisant les tensions Vin, Va et Vb sans utiliser la tension intermédiaire. La précision est donc accrue. En comparaison du document US 8,344,926, le convertisseur est plus compact car une partie des composants est mutualisée. L'amplificateur étant mutualisé, les dérives dans le temps sont plus facilement corrigeables. Le convertisseur comportant moins d'éléments, il existe moins de dispersion dans les résultats. En effet, dans l'art antérieur afin de limiter l'encombrement, l'amplificateur formant le multiplicateur par deux (X2) était choisi avec des performances modestes. Cependant, il est apparu que cela entrainait une dispersion importante des résultats sur la valeur du premier bit. Dans les modes de réalisation présentés, en plus du gain en compacité, il existe un gain sur la précision des résultats obtenus. Cette altération des résultats des circuits de l'art antérieur peut se retrouver sur la tension V2 et sur les bits à suivre ce qui nécessite un travail important de calibration.

Dans un mode de réalisation avantageux de ce convertisseur analogique-numérique sur deux bits, la conversion est réalisée à chaque itération et se décompose en une pluralité de phases élémentaires qui peuvent comporter chacune un ou plusieurs cycles d'horloge. En effet, à titre d'exemple, selon la quantité de dispositifs échantillonneur-bloqueur intégrés dans le convertisseur et leur disposition dans le circuit, le nombre de coup d'horloge va évoluer pour obtenir un résultat similaire à 4Vin -(Va+Vb)+ *Bi*.(Va-Vb)+*B̅i*.(Vb-Va) -(Va+Vb)/2 +*B*_{*i*+1} .(Va-Vb)/2+*B̅*_{*i*+1} (Vb-Va)/2.

A titre d'exemple illustré à la figure 8, un fonctionnement possible du mode de réalisation illustré à la figure 4 est explicité pour une itération. Dans une première période commençant à l'instant ta, la tension à convertir Vin est appliquée à l'entrée du convertisseur. Dans cette première période, à un instant t₁, la tension à convertir Vin est échantillonnée.

A l'instant t₁, la tension à convertir Vin est comparée à la première tension de comparaison Vref1, suivant que la tension à convertir Vin est supérieure ou inférieure à la tension de comparaison Vref1, le comparateur délivre un premier bit *Bi* égal respectivement à 1 ou 0.

Avantageusement, la comparaison à la tension de comparaison Vref1 est réalisée en fin de période, juste avant t₂, quand le signal est bien établi.

A l'instant t₂, la seconde période commence. Le deuxième interrupteur T2 est passant et le calculateur délivre la tension intermédiaire V1. Le calcul est réalisé notamment en fonction du premier bit Bi déterminé durant la première période.

A l'instant t₃, la tension intermédiaire V1 est comparée à la tension de comparaison. Suivant que la tension intermédiaire V1 est supérieure ou inférieure à la tension de comparaison Vref2, le comparateur délivre un second bit *B*_{*i*+1} égal respectivement à 1 ou 0. La comparaison est réalisée de préférence en fin de deuxième période mais surtout avant le début de la troisième période.

Dans la troisième période commençant à l'instant t₄, le calculateur calcule la tension résiduelle V2, en fonction du premier bit *Bi,* déterminé à l'instant t₁, du second bit *B*_{*i*+1} déterminé à l'instant t₃. La première tension intermédiaire V1 n'est pas utilisée par le calculateur 6 afin de ne pas introduire les erreurs liées au calcul de la tension V1 dans le calcul de la tension résiduelle V2.

Comme illustré à la figure 8, le générateur de premier signal S1 rend les interrupteurs associés passant entre les instants t₀ et t₂. A l'instant t₂, le générateur de premier signal S1 rend les interrupteurs associés bloquant. A l'instant t₂, le générateur de deuxième signal S2 rend les interrupteurs associés passant. A l'instant t₄, le générateur de troisième signal S3 rend les interrupteurs associés passant. Les interrupteurs associés au signal S2 sont à l'état passant et ceux associés au signal S1 sont à l'état bloquant. A l'instant t₅, le générateur de deuxième signal S2 et le générateur de troisième signal S3 rendent les interrupteurs associés bloquant. A l'instant t₅, le générateur de premier signal S1 rend les interrupteurs associés passant.

De manière générale, le convertisseur réalise dans un premier temps, l'extraction du premier bit *Bi* puis dans un deuxième temps, l'extraction du deuxième bit *B*_{*i*+1} au moyen de la tension Vin, des première Va et seconde Vb tensions et du premier bit. De cette façon, le convertisseur ne permet pas une augmentation de la vitesse de conversion, mais autorise une augmentation de la précision de la conversion et une réduction de la consommation énergétique.

Dans un mode de réalisation privilégié, illustré à la figure 9, les moyens de comparaisons 2 et 5 comportent une architecture de type RSD (« Redundant signed digit » en anglais) qui permet un fonctionnement plus robuste du convertisseur. Au moyen de cette architecture particulière, les imprécisions liées aux comparateurs présents dans les moyens de comparaison 2 et 5 sont réduites. La gamme accessible à la tension à convertir Vin et aux tensions intermédiaire est divisée en un nombre impair de sous-gammes, par exemple trois sous-gammes. Pour un découpage en trois sous-gammes, les moyens de comparaison 2 et 5 comportent chacun deux comparateurs élémentaires. Les moyens de comparaison délivrent alors un résultat numérique sur deux bits. Cependant, ces deux bits ne pouvant pas prendre toutes les valeurs possibles, il est nécessaire de retravailler ce signal numérique pour en faire un véritable signal binaire. Les premiers comparateurs élémentaires des moyens de comparaison 2 et 5 ont une première borne d'entrée connectée à une première tension de comparaison élémentaire Vref- et ont une seconde borne d'entrée connectée respectivement à la tension à convertir Vin et à la première tension intermédiaire. De cette manière, les premiers comparateurs élémentaires réalisent la comparaison de la tension à convertir ou de la première tension intermédiaire V1 à la première tension de comparaison élémentaire. Une connexion et un fonctionnement similaires sont réalisés pour les seconds comparateurs élémentaires des moyens de comparaison 2 et 5. Les seconds comparateurs élémentaires réalisent la comparaison de la tension à convertir Vin ou de la première tension intermédiaire V1 avec la seconde tension de comparaison élémentaire Vref⁺.

Dans ce mode de réalisation particulier, la gamme accessible à la tension à convertir Vin est divisée en trois sous-gammes au moyen des première et seconde tensions de comparaison élémentaire Vref- et Vref⁺. Les première et seconde tensions de comparaison élémentaire sont des tensions qui se situent dans la gamme définie par les première Va et seconde Vb tensions. La gamme de tension accessible étant divisée en trois sous-gammes égales ou non, les moyens de comparaison 2 et 5 délivrent chacun en sortie deux bits élémentaires*Bi*⁻, *Bi*⁺ et *B*_{*i*+1}*⁻*, *B*_{*i*+1}⁺. Les valeurs des différents bits représentent le positionnement de la tension à convertir Vin ou de la première tension intermédiaire V1 dans la gamme accessible. De ce fait, toutes les combinaisons entre les bits *Bi⁻* et *Bi*⁺ ou entre les bits *B*_{*i*+1}⁻ et *B*_{*i*+1}⁺ ne sont pas possibles. Dans ce mode de réalisation particulier, le convertisseur comporte des moyens de transcription des bits élémentaires obtenus sur les différentes itérations en un format binaire représentatif de la tension à convertir Vin. La réalisation d'un convertisseur suivant une architecture de type RSD est décrit par exemple par Ginetti et al dans la publication citée précédemment.

Dans cette architecture particulière, le calculateur prend en compte la présence des deux bits élémentaires délivrés par les moyens de comparaisons 2 et 5. En définissant, (Va+Vb)/2 ≤ Vref⁺ < (Va+Vb)/2 + (Vb-Va)/4 et (Va+Vb)/2 + (Va-Vb)/4 < Vref⁻ ≤ (Va+Vb)/2, la tension délivrée par le moyen de calcul peut être définie comme étant égale à 2Vin - (*Bi*⁻ ET *Bi*⁺).Vb - (*Bi*⁻ OUEX *Bi*⁺).(Va+Vb)/2 - (*B̅i̅⁻̅*ET *̅B̅i̅*̅⁺̅).Va, la tension résiduelle V2 délivrée par le moyen de calcul peut, pour sa part être définie comme étant égale à 4Vin - 2(*Bi*⁻ ET *Bi*⁺).Vb - 2(*Bi*⁻ OUEX *Bi*⁺ ).(Va+Vb)/2 - 2(*̅B̅i̅*̅⁻̅ ET *̅B̅i̅*̅⁺̅).Va - (*B*_{*i*+1}⁻ ET *B*_{*i*+1}⁺). Vb - (*B*_{*i*+1}⁻ OUEX *B*_{*i*+1}⁺ ).(Va+Vb)/2 - (*B*_{*i*+1}⁻ ET *B*_{*i*+1}⁺).Va. ET et OUEX (ou exclusif) représentent les opérateurs booléens. Ces équations peuvent également être écrites sous la même forme que précédemment. Cette architecture est avantageuse, car un comparateur moins performant peut être utilisé.

Cette architecture particulière permet également d'augmenter la précision du convertisseur pour une même résolution numérique, c'est-à-dire pour une conversion sur un même nombre de bits. Au moyen d'un tel convertisseur qui intègre un moyen de calcul sur deux signaux binaires, les dégradations du signal analogique en sortie A du convertisseur sont réduites par rapport à l'utilisation de deux étages successifs ayant chacun leurs propres moyens de calcul de tensions intermédiaires. De plus, cette séparation du codage numérique et du calcul d'un résidu analogique permet d'optimiser les propriétés de ces deux branches et de délivrer en sortie du convertisseur un résidu, c'est-à-dire une seconde tension intermédiaire, avec une meilleure précision. Cette seconde tension intermédiaire étant utilisée pour l'obtention des deux bits successifs, il en résulte alors une augmentation de la précision du code binaire provenant de la conversion de la tension Vin. Cette architecture permet également une réduction de la consommation et de l'encombrement par rapport aux autres convertisseurs analogique-numérique sur deux bits (c'est-à-dire deux convertisseurs sur un bit mis en série), ce qui en fait une architecture particulièrement avantageuse.

Ce mode de réalisation avantageux est présenté en relation avec le mode de réalisation de la figure 4. En variante, ce mode de réalisation peut également être utilisé dans le mode de réalisation illustré à la figure 3.

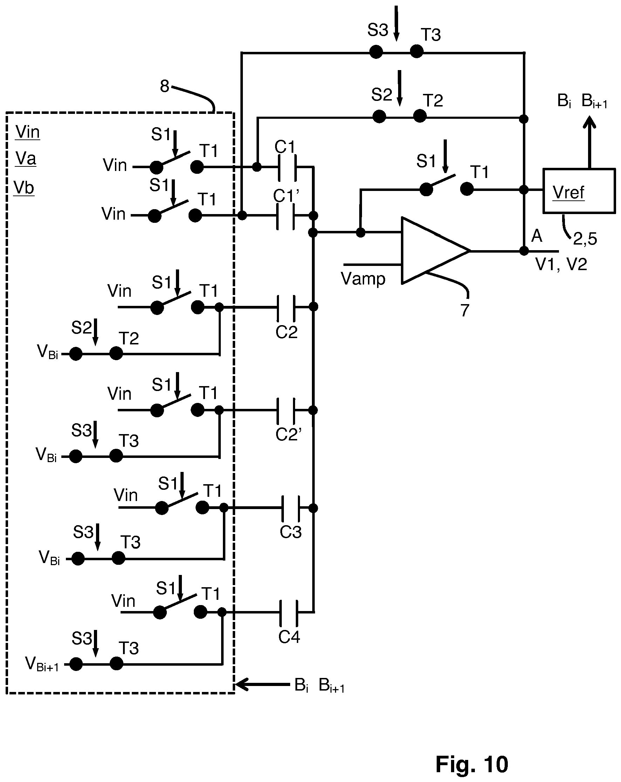

Dans un mode de réalisation avantageux illustré à la figure 10, le convertisseur comporte deux lignes d'alimentation additionnelles montées en parallèle des quatre lignes d'alimentation déjà décrites. Les deux lignes d'alimentation additionnelles sont semblables aux précédentes avec un premier interrupteur T1 qui reçoit le signal S1 pour autoriser ou bloquer l'application de la tension Vin sur une deuxième borne du condensateur additionnel.

La première ligne d'alimentation additionnelle comporte un premier condensateur additionnel C1'. La seconde borne du premier condensateur additionnel C1' est connectée à la sortie de l'amplificateur A au moyen d'un troisième interrupteur T3 qui reçoit le signal S3. La première borne du condensateur C1' est connectée à l'amplificateur 7.

La deuxième ligne d'alimentation additionnelle comporte un deuxième condensateur additionnel C2'. La seconde borne du deuxième condensateur additionnel C2' est connectée pour recevoir la première tension de référence V_{Bi} par l'intermédiaire d'un troisième interrupteur T3 qui reçoit le signal S3.

La valeur de capacité électrique du premier condensateur C1 est égale à la valeur du deuxième condensateur C2. La somme des valeurs des capacités électriques du premier condensateur C1 et du premier condensateur additionnel C1' est égale à la somme des valeurs des capacités électriques du deuxième condensateur C2 et du premier condensateur additionnel C2'. La somme des valeurs des capacités électriques du premier condensateur C1 et du premier condensateur additionnel C1' est égale à la valeur de capacité électrique du troisième condensateur C3 et du quatrième condensateur (C1+C1'=C2+C2'=C3=C4 ; C1=C2 ; C1'=C2').

Réduire la valeur de capacité électrique des premier et deuxième condensateurs C1 et C2 permet d'atteindre plus rapidement un état stationnaire. Il est alors possible de calculer la première tension V1 et de déterminer le deuxième bit *B*_{*i*+1} plus rapidement. En comparaison des modes de réalisation précédents, un résultat plus précis peut être obtenu et/ou sur une période de temps plus courte.

De manière particulièrement avantageuse afin de réduire le temps pour charger les condensateurs C1 et C2, la valeur de C1 est inférieure à la moitié de la valeur de C1' et encore plus préférentiellement C1=C1710.

Le mode de réalisation illustré à la figure 10 peut être mis en oeuvre avec les comparateurs de la figure 4 ou avec les comparateurs de la figure 9.

Il est alors possible de combiner les différentes architectures proposées de convertisseur sans rendre le chronogramme plus complexe.

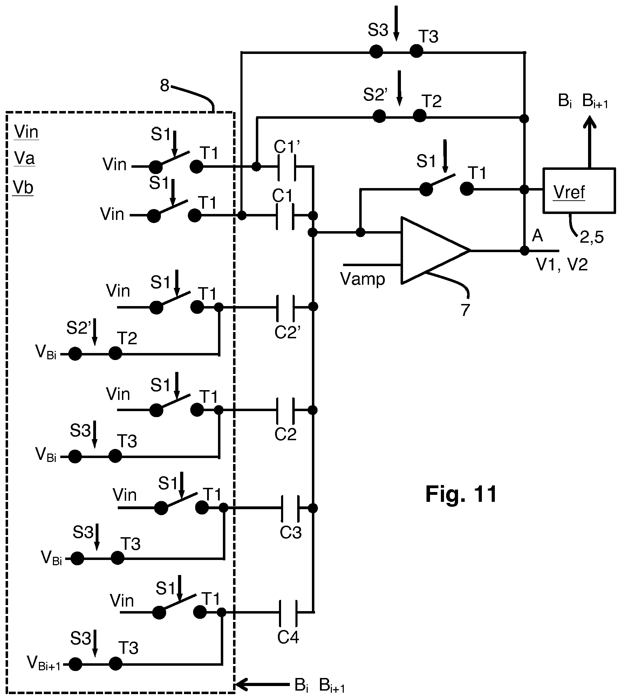

Dans une variante de réalisation illustrée à la figure 11, la valeur de capacité électrique du premier condensateur C1 est égale à la valeur du deuxième condensateur C2. La somme des valeurs des capacités électriques du premier condensateur C1 et du premier condensateur additionnel C1' est égale à la somme des valeurs des capacités électriques du deuxième condensateur C2 et du premier condensateur additionnel C2'. La valeur des capacités électriques des premier et deuxième condensateurs additionnels C1' et C2' est égale à la valeur de capacité électrique du troisième condensateur C3 et du quatrième condensateur C4 (C1'=C2'=C3=C4). La valeur de capacité électrique du premier condensateur C1 est inférieure à la valeur du premier condensateur additionnel C1' d'au moins 10%.

Réduire la valeur de capacité électrique des premier et deuxième condensateurs C1 et C2 permet d'atteindre plus rapidement un état stationnaire. Il est alors possible de calculer la première tension V1 et de déterminer le deuxième bit *B*_{*i*+1} plus rapidement. En comparaison des modes de réalisation précédents, un résultat plus précis peut être obtenu et/ou sur une période de temps plus courte. Ce mode de réalisation est moins compact que le précédent.

De manière particulièrement avantageuse afin de réduire le temps pour charger les condensateurs C1 et C2, la valeur de C1 est inférieure à la moitié de la valeur de C1' et encore plus préférentiellement C1=C1710.

Ce mode de réalisation est particulièrement avantageux car les signaux stockés sur les condensateurs C1 et C2 sont utilisés pour déterminer le deuxième bit Bᵢ₊₁, mais pas pour calculer la tension V2. Les charges parasites émises par l'amplificateur lors de la lecture des signaux pour déterminer le deuxième bit Bᵢ₊₁ ne sont pas stockées dans les condensateurs C1' et C2' ce qui assure une meilleure précision pour les conversions à suivre. Il est alors avantageux de remplacer le signal S2 par le signal S2'. Le signal S2' est configuré pour rendre le deuxième interrupteur T2 bloquant lorsque le troisième interrupteur T3 devient passant.

Les signaux S2 et S2' sont illustrés dans le chronogramme de la figure 8.

Dans un mode de réalisation avantageux, quand le convertisseur est dans une architecture dite « pipeline », les deux étages successifs sont en opposition de phase. Dans ces conditions, l'un des étages réalise l'échantillonnage pendant que l'autre étage réalise l'opération de multiplication et inversement.

De manière encore plus générale, le convertisseur à approximations successives peut délivrer plus de deux bits avec plus d'étages. Il comporte alors une succession d'étages d'approximation avec au moins deux fois moins d'étages que de bits délivrés. Dans le cas où le convertisseur comporte une pluralité d'étages, chaque étage comporte une entrée et une sortie analogique, un calculateur et au moins un comparateur selon le type de découpage de la gamme de conversion. Chaque étage délivre un résultat numérique sur une sortie numérique, par exemple un bit et une tension analogique sur la sortie analogique. C'est cette tension analogique qui sert à déterminer le résultat numérique de l'étage suivant ou la tension résiduelle du convertisseur.

Chaque calculateur est connecté à la borne d'entrée du convertisseur pour recevoir la tension d'entrée Vin, à son comparateur associé pour recevoir le résultat numérique de son étage et aux comparateurs des étages précédents délivrant des bits de poids plus forts afin de calculer et délivrer la tension analogique de cet étage. Chaque comparateur est connecté à la borne de sortie de l'étage précédent afin de délivrer un résultat numérique représentatif de la tension analogique de l'étage précédent. Un étage reçoit donc un signal analogique provenant de l'étage précédent pour déterminer une valeur numérique et il délivre une tension analogique à l'étage suivant. La sortie analogique A du convertisseur est connectée à une entrée du second calculateur, c'est-à-dire le calculateur du second étage.

Le convertisseur a été présenté de manière à fournir 2 bits par étage mais il est également possible de délivrer plus de bits en utilisant la même architecture générale et notamment en utilisant le même amplificateur 7 pour délivrer toutes les tensions intermédiaires Vi et la tension résiduelle.

Le comparateur connecté à la sortie de l'amplificateur 7 est utilisé pour délivrer tous les bits ou au moins tous les bits à l'exception du premier bit.

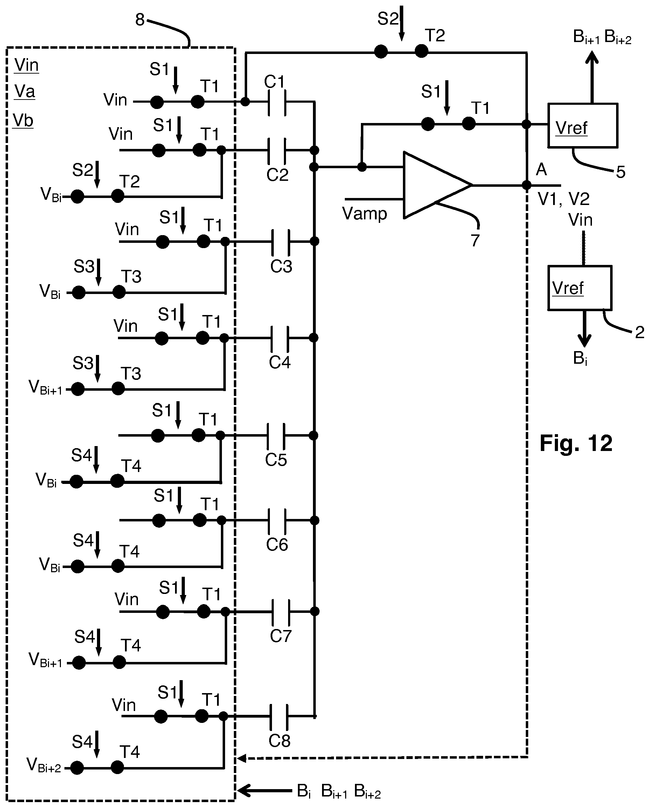

Dans le mode de réalisation illustré à la figure 12 et qui reprend l'architecture présentée dans le mode de réalisation de la figure 4, le convertisseur comporte 8 lignes d'alimentation montées en parallèles et il permet de délivrer 3 bits par étage.

Le convertisseur sur 3 bits comporte tous les éléments du convertisseur sur 2 bits. Il comporte en plus des lignes d'alimentation supplémentaires, un générateur de signal supplémentaire et au moins une tension de référence supplémentaire. Les différents modes de réalisation du convertisseur sur 2 bits peuvent être utilisés.

Les quatre lignes d'alimentation supplémentaires sont une reproduction des configurations des lignes d'alimentation précédentes à l'exception de la première ligne d'alimentation. La cinquième ligne est un identique à la deuxième ligne. La sixième ligne est identique à la troisième ligne. La septième ligne est identique à la quatrième ligne. La huitième ligne d'alimentation comporte un huitième condensateur C8 qui peut recevoir la tension Vin par l'intermédiaire d'un premier interrupteur commandé par le signal S1 ou la troisième tension de référence V_{Bi+2} par l'intermédiaire d'un quatrième interrupteur commandé par le signal S4.

Sur ces quatre lignes supplémentaires, les première, deuxième et troisième tensions de référence sont appliquées sur les condensateurs par l'intermédiaire d'un quatrième interrupteur commandé par un signal S4 de manière à pouvoir définir un nouvelle période de comparaison et de calcul d'une nouvelle tension qui va devenir la tension résiduelle.

Les première, deuxième et troisième périodes sont identiques à ce qui a été décrit précédemment. Durant la troisième période, la tension délivrée par l'amplificateur 7 est comparée à une troisième tension de comparaison qui est avantageusement égale à la première et à la deuxième tensions de comparaison Vref.

Durant la quatrième période, les deuxièmes, troisièmes et quatrièmes interrupteurs sont à l'état passant et l'amplificateur délivre la tension résiduelle qui est fonction de la tension Vin, des tensions Va et Vb et des valeurs des premier, deuxième et troisième bits. Les premiers interrupteurs sont à l'état bloquant. Selon les modes de réalisation, les deuxième et troisième interrupteurs sont à l'état bloquant ou passant.

Le chronogramme de la figure 13 illustre un fonctionnement possible pour un convertisseur sur 3 bits. Il reprend le schéma du chronogramme de la figure 8 et il définit une quatrième période où les quatrièmes interrupteurs basculent à l'état passant. A l'instant t₆, le signal S4 fait basculer les quatrièmes interrupteurs à l'état passant. A l'instant t₇, le comparateur compare la tension délivrée par l'amplificateur à une tension de comparaison pour délivrer la troisième information numérique, ici le troisième bit Bᵢ₊₂. A l'instant t₅, les deuxièmes, troisièmes et quatrièmes interrupteurs basculent à l'état bloquant.

Le convertisseur sur 3 bits peut également intégrer les différentes variantes de réalisation présentées pour le convertisseur sur 2 bits, par exemple les variantes de réalisation illustrées au figures 10 et 11 car le convertisseur sur 3 bits comporte les éléments du convertisseur du 2 bits. Les avantages présentés plus haut sont conservés. De manière générale, le convertisseur sur n bits peut intégrer les différentes variantes de réalisation présentées pour le convertisseur sur 2 bits.

De manière plus générale, le convertisseur peut être configuré pour délivrer n bits avec n entier supérieur à 2. Pour délivrer n bits, l'architecture présentée est identique à ce qui a été présenté pour 2 bits et 3 bits.

Le convertisseur comporte 2n lignes d'alimentation qui possèdent chacune un condensateur. La source de tension est reliée à chacune des lignes d'alimentation et délivre la tension adaptée pour chacune des au moins n+1 périodes utilisées.

Le convertisseur calcule n tensions, c'est-à-dire n-1 tensions intermédiaires et une tension résiduelle. La tension à convertir Vin et les n-1 tensions intermédiaires sont comparées à des tensions de comparaison pour délivrer les n bits du convertisseur.

La conversion est réalisée en utilisant au moins n+1 périodes et donc avantageusement n+1 générateurs de signaux et n+1 séries d'interrupteurs afin de fournir les tensions Vᵢₙ, V_{Bi}, V_{Bi+1}, V_{Bi+2}... et V_{Bi+n-1} sur les deuxièmes bornes des condensateurs.

Le convertisseur délivrant n bits comporte
- 2ⁿ lignes d'alimentations montées en parallèle avec chacune un condensateur,
- chaque ligne d'alimentation reçoit la tension Vin au moyen d'un premier transistor recevant le signal S1.

Le convertisseur délivrant n bits comporte les mêmes éléments que le convertisseur délivrant n-1 bits. Il fonctionne avantageusement de la même manière pour calculer les tensions intermédiaires et calculer les n-1 premiers bits.

Un convertisseur sur n bits comporte un convertisseur sur n-1 bits et également 2ⁿ⁻¹ lignes d'alimentation supplémentaires. Ces 2ⁿ⁻¹ lignes supplémentaires comportent chacune un condensateur qui est connecté à la source de tension 8. La source de tension 8 est configurée pour délivrer toutes les tensions de référence jusqu'au rang n au moyen de 2ⁿ⁻¹ sorties supplémentaires qui sont une copie des sorties utilisées par le convertisseur de rang n-1 pour délivrer les tensions de référence. La dernière sortie supplémentaire est utilisée pour délivrer la dernière tension de référence nécessaire au calcul de la tension résiduelle.

La source de tension 8 est configurée pour appliquer la tension Vin durant la première période sur les 2ⁿ⁻¹ sorties supplémentaires. La source de tension 8 est configurée pour appliquer la dernière tension de référence durant la période de rang n+1. Un tel convertisseur est particulièrement avantageux car il utilise un amplificateur 7 pour calculer les diverses tensions intermédiaires et la tension résiduelle. La tension résiduelle du convertisseur sur 2 bits est la dernière tension intermédiaire du convertisseur sur 3 bits et la tension résiduelle du convertisseur sur 3 bits sera la dernière tension intermédiaire du convertisseur sur 4 bits.

De manière avantageuse, le convertisseur comporte un circuit de commande qui est configuré pour réaliser les différentes étapes décrites précédemment.

## Revendications

1. Convertisseur analogique-numérique comportant :
- une borne d'entrée recevant une tension à convertir (Vin), la tension à convertir étant comprise dans une gamme de conversion délimitée par des première (Va) et seconde (Vb) tensions,
- un amplificateur (7) ayant une première borne d'entrée et une borne de sortie formant une borne de sortie analogique du convertisseur,
- un premier interrupteur (T1) reliant la borne d'entrée de l'amplificateur (7) et la borne de sortie de l'amplificateur (7),
- des premier, deuxième, troisième et quatrième condensateurs (C1, C2, C3, C4) ayant une première borne connectée à la première borne d'entrée de l'amplificateur (7),
- un deuxième interrupteur (T2) reliant une deuxième borne du premier condensateur (C1) à la borne de sortie de l'amplificateur (7),
- un premier comparateur (2) recevant la tension à convertir (Vin) et au moins une première tension de comparaison (Vref1) et configuré pour réaliser la comparaison entre la tension à convertir (Vin) et la au moins une première tension de comparaison (Vref1), et délivrer, sur une première sortie numérique, une première valeur numérique (*Bi*) sur au moins un premier bit représentatif de ladite comparaison,
- un second comparateur (5) recevant une première tension intermédiaire (V1) et au moins une seconde tension de comparaison (Vref2) et configuré pour réaliser la comparaison entre la première tension intermédiaire (V1) et la au moins une seconde tension de comparaison (Vref2), et délivrer, sur une seconde sortie numérique, une seconde valeur numérique (*B*_{*i*+1}) sur au moins un second bit représentatif de ladite comparaison,
- une source de tension (8) comportant (i) un groupe de premiers d'interrupteurs (T1) reliant un générateur de la tension à convertir (Vin) aux secondes bornes des premier, deuxième, troisième et quatrième condensateurs (C4), les premiers interrupteurs (T1) ayant une électrode de commande reliée à un générateur d'un premier signal (S1), (ii) un groupe de deuxième interrupteurs (T2) reliant un générateur de la première tension de référence (V_{Bi}) à la seconde borne du deuxième condensateur (C2), les deuxièmes interrupteurs (T2) ayant une électrode de commande reliée à un générateur d'un deuxième signal (S2), (iii) un groupe de troisième interrupteurs (T3) reliant le générateur de la première tension de référence (V_{Bi}) à la seconde borne du troisième condensateurs (C3) et reliant un générateur de la deuxième tension de référence (V_{Bi+1}) à la seconde borne du quatrième condensateur (C4), les troisièmes interrupteurs (T3) ayant une électrode de commande reliée à un générateur d'un troisième signal (S3), la source de tension (8) étant configurée pour :
∘ appliquer la tension à convertir (Vin) sur une deuxième borne des premier, deuxième, troisième et quatrième condensateurs (C1, C2, C3, C4) pendant une première période, le groupe de premiers d'interrupteurs (T1) étant à l'état passant pendant la première période et à l'état bloquant pendant des deuxième et troisième périodes,
∘ appliquer une première tension de référence (V_{Bi}) sur la deuxième borne du deuxième condensateur (C2) durant la deuxième et la troisième périodes, la première tension de référence (V_{Bi}) étant représentative de la première valeur numérique (*Bi*), le groupe de deuxièmes interrupteurs (T2) étant à l'état passant pendant les deuxième et troisième périodes et à l'étant bloquant pendant la première période,
∘ appliquer la première tension de référence (V_{Bi}) sur la deuxième borne du troisième condensateur (C3) durant la troisième période et appliquer une deuxième tension de référence (V_{Bi+1}) sur la deuxième borne du quatrième condensateur (C4) durant la troisième période, la deuxième tension de référence (V_{Bi+1}) étant représentative de la seconde valeur numérique (*B*_{*i*+1}), le groupe de troisième interrupteurs (T3) étant à l'état passant pendant la troisième période et à l'étant bloquant pendant les première et deuxièmes périodes,
- un circuit de commande configuré pour calculer, au moyen de l'amplificateur (7) et du deuxième interrupteur (T2),
∘ la première tension intermédiaire (V1) à partir de la tension à convertir (Vin), de la première valeur numérique (*Bi*) et desdites première (Va) et seconde (Vb) tensions,
∘ une deuxième tension intermédiaire (V2) à partir de la tension à convertir (Vin), des première et deuxième valeurs numériques (*Bi*, *B*_{*i*+1}) et desdites première (Va) et seconde (Vb) tensions
le circuit de commande étant configuré pour que le deuxième interrupteur (T2) soit à l'état bloquant durant la première période et à l'état passant durant la deuxième période et la troisième période.

2. Convertisseur selon la revendication 1 **caractérisé en ce que** le premier comparateur (2) et le second comparateur (5) sont formés par un même comparateur et **en ce qu'**il comporte un commutateur configuré pour connecter la borne d'entrée du comparateur (2, 5) à la borne de sortie de l'amplificateur (7) ou à la borne d'entrée recevant la tension à convertir (Vin).

3. Convertisseur selon l'une quelconques des revendications 1 et 2, **caractérisé en ce que** la valeur de la première tension de référence (V_{Bi}) dépend uniquement de la première valeur numérique (*Bi*).

4. Convertisseur selon l'une quelconques des revendications 1 à 3, **caractérisé en ce que** la valeur de la deuxième tension de référence (V_{Bi+1}) dépend uniquement de la deuxième valeur numérique (*B*_{*i*+1}).

5. Convertisseur selon l'une quelconques des revendications précédentes, **caractérisé en ce que** la deuxième tension intermédiaire (V2) est représentative de 4Vin - (Va+Vb) + *Bi*.(Va-Vb) + *B̅i*.(Vb-Va) - (Va+Vb)/2 + *B*_{*i*+1}.(Va-Vb)/2 + *B̅*_{*i*+1}.(Vb-Va)/2.

6. Convertisseur selon l'une des revendications 1 et 2, **caractérisé en ce que** le premier comparateur (2) est constitué par deux comparateurs (2a, 2b) sur un bit délivrant une première valeur numérique définie par des premier et deuxième bits élémentaires (*Bi*⁻, *Bi*⁺).

7. Convertisseur selon la revendication précédente, **caractérisé en ce que** le second comparateur (5) est constitué par deux comparateurs (2a, 2b) sur un bit délivrant une deuxième valeur numérique définie par des troisième et quatrième bits élémentaires (*B*_{*i*+1}⁻ , *B*_{*i*+1}⁺).

8. Convertisseur selon la revendication 7, **caractérisé en ce que** la deuxième tension intermédiaire (V2) est représentative de 4Vin - *2*(*Bi⁻* ET *Bi*⁺).Vref⁺ - 2(*Bi*⁻OU *Bi*⁺).(Va+Vb)/2 - 2(*B̅i̅⁻̅* ET *̅B̅i̅*̅⁺̅).Vref- - (*B*_{*i*+1},*⁻* ET *B*_{*i*+1}⁺).Vref⁺ - (*B*_{*i*+1}*⁻* OU *B*_{*i*+1}⁺ ).(Va+Vb)/2 - (*̅B̅*̅_̅{̅*̅i̅*̅+̅1̅}̅*⁻̅* ET *̅B̅*̅_̅{̅*̅i̅*̅+̅1̅}̅⁺̅).Vref⁻.

9. Convertisseur selon l'une quelconque des revendications précédentes, **caractérisé en ce qu'**il comporte un premier et un deuxième condensateurs additionnels (C1', C2'), les premier et deuxième condensateurs additionnel (C1', C2') ayant une première borne connectée à la première borne d'entrée de l'amplificateur (7), la seconde borne du premier condensateur additionnel (C1') étant connectée à la sortie de l'amplificateur (7) au moyen d'un troisième interrupteur (T3) du groupe de troisième interrupteurs (T3), la seconde borne du deuxième condensateur additionnel (C2') est connectée pour recevoir la première tension de référence (V_{Bi}) par l'intermédiaire d'un troisième interrupteur (T3) du groupe de troisième interrupteurs (T3).

10. Convertisseur selon l'une quelconque des revendications précédentes, **caractérisé en ce que** le premier interrupteur (T1) est configuré pour connecter directement la borne d'entrée de l'amplificateur (7) et la borne de sortie de l'amplificateur (7).

11. Procédé de fonctionnement d'un convertisseur analogique-numérique comportant :
- fournir un convertisseur analogique-numérique comportant
∘ un amplificateur (7) ayant une première borne d'entrée et une borne de sortie formant une borne de sortie analogique du convertisseur,
∘ un premier interrupteur (T1) reliant la borne d'entrée de l'amplificateur (7) et la borne de sortie de l'amplificateur (7),
∘ des premier, deuxième, troisième et quatrième condensateurs (C1, C2, C3, C4) ayant une première borne connectée à la première borne d'entrée de l'amplificateur (7),
- échantillonner une tension à convertir (Vin) durant une première période en appliquant ladite tension à convertir à des deuxièmes bornes des premier, deuxième, troisième et quatrième condensateurs (C1, C2, C3, C4), la tension à convertir (Vin) étant comprise dans une gamme de conversion délimitée par des première (Va) et seconde (Vb) tensions, l'amplificateur (7) étant monté en suiveur au moyen du premier interrupteur (T1),
- comparer la tension à convertir (Vin) à une première tension de comparaison (Vref1) au moyen d'un premier comparateur (2) et délivrer une première valeur numérique (*Bi*) sur au moins un premier bit,
- durant une deuxième période, appliquer une première tension de référence (V_{Bi}) sur la deuxième borne du deuxième condensateur (C2), la première tension de référence (V_{Bi}) étant représentative de la première valeur numérique (*Bi*), le premier condensateur (C1) étant monté entre la première borne d'entrée et la borne de sortie de l'amplificateur (7), le premier interrupteur (T1) étant à l'état bloquant, les deuxièmes bornes des deuxième et troisième condensateurs (C3, C4) étant à un potentiel flottant,
- calculer une première tension intermédiaire (V1) au moyen de l'amplificateur (7) et des premier et deuxième condensateurs (C1, C2), à partir de la tension à convertir (Vin) et de la première tension de référence (V_{Bi}), durant la deuxième période,
- comparer la première tension intermédiaire (V1) à une deuxième tension de comparaison (Vref2) au moyen d'un deuxième comparateur (5) et délivrer une seconde valeur numérique (*B*_{*i*+1}) sur au moins un second bit, le premier condensateur (C1) étant monté entre la première borne d'entrée et la borne de sortie de l'amplificateur (7), le premier interrupteur (T1) étant à l'état bloquant,
- durant une troisième période, appliquer la première tension de référence (V_{Bi}) sur la seconde électrode du troisième condensateur (C3) et appliquer une deuxième tension de référence (V_{Bi+1}) sur la deuxième borne du quatrième condensateur (C4), la deuxième tension de référence (V_{Bi+1}) étant représentative de la seconde valeur numérique (*B*_{*i*+1}), le premier condensateur (C1) étant monté entre la première borne d'entrée et la borne de sortie de l'amplificateur (7), le premier interrupteur (T1) étant à l'état bloquant, la première tension de référence (V_{Bi}) étant appliquée sur la deuxième borne du deuxième condensateur (C2),
- calculer une deuxième tension intermédiaire (V2) au moyen de l'amplificateur (7) et des premier, deuxième, troisième et quatrième condensateurs (C1, C2, C3, C4), à partir de la tension à convertir (Vin), de la première tension de référence (V_{Bi}) et de la deuxième tension de référence (V_{Bi+1}), durant la troisième période.

## Patentansprüche

1. Analog-Digital-Wandler, umfassend:
- einen Eingangsanschluss, der eine umzuwandelnde Spannung (Vin) empfängt, wobei die umzuwandelnde Spannung in einem Umwandlungsbereich liegt, der durch eine erste Spannung (Va) und eine zweite (Vb) Spannung begrenzt wird,
- einen Verstärker (7), der einen ersten Eingangsanschluss und einen Ausgangsanschluss aufweist, der einen analogen Ausgangsanschluss des Wandlers bildet,
- einen ersten Schalter (T1), der den Eingangsanschluss des Verstärkers (7) und den Ausgangsanschluss des Verstärkers (7) verbindet,
- einen ersten, zweiten, dritten und vierten Kondensator (C1, C2, C3, C4), deren erster Anschluss mit dem ersten Eingangsanschluss des Verstärkers (7) verbunden ist,
- einen zweiten Schalter (T2), der einen zweiten Anschluss des ersten Kondensators (C1) mit dem Ausgangsanschluss des Verstärkers (7) verbindet,
- einen ersten Komparator (2), der die umzuwandelnde Spannung (Vin) und mindestens eine erste Vergleichsspannung (Vref1) empfängt und dazu konfiguriert ist, den Vergleich zwischen der umzuwandelnden Spannung (Vin) und der mindestens einen ersten Vergleichsspannung (Vref1) durchzuführen und an einem ersten digitalen Ausgang einen ersten digitalen Wert (Bᵢ) mit mindestens einem ersten Bit auszugeben, das für den Vergleich repräsentativ ist,
- einen zweiten Komparator (5), der eine erste Zwischenspannung (V1) und mindestens eine zweite Vergleichsspannung (Vref2) empfängt und dazu konfiguriert ist, den Vergleich zwischen der ersten Zwischenspannung (V1) und der mindestens einen zweiten Vergleichsspannung (Vref2) durchzuführen und an einem zweiten digitalen Ausgang einen zweiten digitalen Wert (*B*_{*i*+1}) mit mindestens einem zweiten Bit auszugeben, das für den Vergleich repräsentativ ist,
- eine Spannungsquelle (8), umfassend (i) eine Gruppe von ersten Schaltern (T1), die einen Generator der umzuwandelnden Spannung (Vin) mit den zweiten Anschlüssen des ersten, zweiten, dritten und vierten Kondensators (C4) verbinden, wobei die ersten Schalter (T1) eine Steuerelektrode aufweisen, die mit einem Generator eines ersten Signals (S1) verbunden ist, (ii) eine Gruppe von zweiten Schaltern (T2), die einen Generator der ersten Referenzspannung (V_{Bi}) mit dem zweiten Anschluss des zweiten Kondensators (C2) verbinden, wobei die zweiten Schalter (T2) eine Steuerelektrode aufweisen, die mit einem Generator eines zweiten Signals (S2) verbunden ist, (iii) eine Gruppe von dritten Schaltern (T3), die den Generator der ersten Referenzspannung (V_{Bi}) mit dem zweiten Anschluss des dritten Kondensators (C3) verbinden und einen Generator der zweiten Referenzspannung (V_{Bi+1}) mit dem zweiten Anschluss des vierten Kondensators (C4) verbinden, wobei die dritten Schalter (T3) eine Steuerelektrode aufweisen, die mit einem Generator eines dritten Signals (S3) verbunden ist, wobei die Spannungsquelle (8) dazu konfiguriert ist:
∘ die umzuwandelnde Spannung (Vin) während einer ersten Periode an einen zweiten Anschluss des ersten, zweiten, dritten und vierten Kondensators (C1, C2, C3, C4) anzulegen, wobei Gruppe von ersten Schaltern (T1) während einer ersten Periode im leitenden Zustand ist und während der zweiten und dritten Periode im Sperrzustand ist,
∘ während der zweiten und der dritten Periode eine erste Referenzspannung (V_{Bi}) an den zweiten Anschluss des zweiten Kondensators (C2) anzulegen, wobei die erste Referenzspannung (V_{Bi}) für den ersten digitalen Wert (Bᵢ) repräsentativ ist, die Gruppe von zweiten Schaltern (T2) während der zweiten und der dritten Periode im leitenden Zustand ist und während der ersten Periode im Sperrzustand ist,
∘ während der dritten Periode die erste Referenzspannung (V_{Bi}) an den zweiten Anschluss des dritten Kondensators (C3) anzulegen und während der dritten Periode eine zweite Referenzspannung (V_{Bi+1}) an den zweiten Anschluss des vierten Kondensators (C4) anzulegen, wobei die zweite Referenzspannung (V_{Bi+1}) für den zweiten digitalen Wert (Bᵢ₊₁) repräsentativ ist, die Gruppe von dritten Schaltern (T3) während der dritten Periode im leitenden Zustand ist und während der ersten und der zweiten Periode im Sperrzustand ist,
- eine Steuerschaltung, die dazu konfiguriert ist, mittels des Verstärkers (7) und des zweiten Schalters (T2) zu berechnen:
∘ die erste Zwischenspannung (V1) unter Verwendung der umzuwandelnden Spannung (Vin), des ersten digitalen Werts (Bᵢ) und der ersten Spannung (Va) und der zweiten Spannung (Vb),
∘ eine zweite Zwischenspannung (V2) unter Verwendung der umzuwandelnden Spannung (Vin), des ersten und des zweiten digitalen Werts (Bᵢ, Bᵢ₊₁) und der ersten Spannung (Va) und der zweiten Spannung (Vb)
wobei die Steuerschaltung dazu konfiguriert ist, dass der zweite Schalter (T2) während der ersten Periode im Sperrzustand ist und während der zweiten Periode und der dritten Periode im leitenden Zustand ist.

2. Wandler nach Anspruch 1, **dadurch gekennzeichnet, dass** der erste Komparator (2) und der zweite Komparator (5) durch einen einzigen Komparator gebildet werden, und dass er einen Umschalter aufweist, der dazu konfiguriert ist, den Eingangsanschluss des Komparators (2, 5) mit dem Ausgangsanschluss des Verstärkers (7) oder mit dem Eingangsanschluss, der die umzuwandelnde Spannung (Vin) empfängt, zu verbinden.

3. Wandler nach einem der Ansprüche 1 und 2, **dadurch gekennzeichnet, dass** der Wert der ersten Referenzspannung (V_{Bi}) allein vom ersten digitalen Wert (Bᵢ) abhängt.

4. Wandler nach einem der Ansprüche 1 bis 3, **dadurch gekennzeichnet, dass** der Wert der zweiten Referenzspannung (V_{Bi+1}) allein vom zweiten digitalen Wert (Bᵢ₊₁) abhängt.

5. Wandler nach einem der vorherigen Ansprüche, **dadurch gekennzeichnet, dass** die zweite Zwischenspannung (V2) für 4Vin - (Va+Vb) + *Bi*.(Va-Vb) + *B̅i*.(Vb-Va) - (Va+Vb)/2 + *B*_{*i*+1}.(Va-Vb)/2 + *B̅*ᵢ₊₁.(Vb-Va)/2 repräsentativ ist.

6. Wandler nach einem der Ansprüche 1 und 2, **dadurch gekennzeichnet, dass** der erste Komparator (2) aus zwei Ein-Bit-Komparatoren (2a, 2b) besteht, die einen ersten digitalen Wert ausgeben, der durch erste und zweite Elementarbits (*Bi*⁻, *Bi⁺*) definiert wird.

7. Wandler nach dem vorherigen Anspruch, **dadurch gekennzeichnet, dass** der zweite Komparator (5) aus zwei Ein-Bit-Komparatoren (2a, 2b) besteht, die einen zweiten digitalen Wert ausgeben, der durch dritte und vierte Elementarbits (*B*_{*i*+1}⁻, *B*_{*i*+1}⁺) definiert wird.

8. Wandler nach Anspruch 7, **dadurch gekennzeichnet, dass** die zweite Zwischenspannung (V2) für 4Vin - 2(*Bi*⁻ UND *Bi*⁺).Vref⁺ *-* 2(*Bi⁻* ODER *Bi*⁺ ).(Va+Vb)/2 - 2(*̅B̅i̅*̅⁻̅ UND *̅B̅i̅*̅⁺̅).Vref⁻ - (*B*_{*i*+1}*⁻* UND *B*_{*i*+1}⁺).Vref+ - (*B*ᵢ₊₁⁻ ODER *B*_{*i*+1}⁺ ).(Va+Vb)/2 - (*̅B̅*̅_̅{̅*̅i̅*̅+̅1̅}̅*⁻̅* UND *̅B̅*̅_̅{̅*̅i̅*̅+̅1̅}̅⁺̅).Vref⁻.repräsentativ ist.

9. Wandler nach einem der vorherigen Ansprüche, **dadurch gekennzeichnet, dass** er einen ersten und einen zweiten Zusatzkondensator (C1', C2') umfasst, wobei der erste und der zweite Zusatzkondensator (C1', C2') einen ersten Anschluss haben, der mit dem ersten Eingangsanschluss des Verstärkers (7) verbunden ist, der zweite Anschluss des ersten Zusatzkondensators (C1') durch einen dritten Schalter (T3) der Gruppe von dritten Schaltern (T3) mit dem Ausgang des Verstärkers (7) verbunden ist, der zweite Anschluss des zweiten Zusatzkondensators (C2') verbunden ist, um die erste Referenzspannung (V_{Bi}) über einen dritten Schalter (T3) der Gruppe von dritten Schaltern (T3) zu empfangen.

10. Wandler nach einem der vorherigen Ansprüche, **dadurch gekennzeichnet, dass** der erste Schalter (T1) dazu konfiguriert ist, den Eingangsanschluss des Verstärkers (7) und den Ausgangsanschluss des Verstärkers (7) direkt zu verbinden.

11. Verfahren zum Betreiben eines Analog-Digital-Wandlers, umfassend:
- Bereitstellen eines Analog-Digital-Wandlers, umfassend
∘ einen Verstärker (7), der einen ersten Eingangsanschluss und einen Ausgangsanschluss aufweist, der einen analogen Ausgangsanschluss des Wandlers bildet,
∘ einen ersten Schalter (T1), der den Eingangsanschluss des Verstärkers (7) und den Ausgangsanschluss des Verstärkers (7) verbindet,
∘ einen ersten, zweiten, dritten und vierten Kondensator (C1, C2, C3, C4), deren erster Anschluss mit dem ersten Eingangsanschluss des Verstärkers (7) verbunden ist,
- Abtasten einer umzuwandelnden Spannung (Vin) während einer ersten Periode durch Anlegen der umzuwandelnden Spannung an zweite Anschlüsse des ersten, zweiten, dritten und vierten Kondensators (C1, C2, C3, C4), wobei die umzuwandelnde Spannung (Vin) in einem Umwandlungsbereich liegt, der durch eine erste Spannung (Va) und eine zweite Spannung (Vb) begrenzt wird, wobei der Verstärker (7) durch den ersten Schalter (T1) als Folger geschaltet ist,
- Vergleichen der umzuwandelnden Spannung (Vin) mit einer ersten Vergleichsspannung (Vref1) durch einen ersten Komparator (2) und Ausgeben eines ersten digitalen Werts *(Bi)* mit mindestens einem ersten Bit,
- während einer zweiten Periode, Anlegen einer ersten Referenzspannung (V_{Bi}) an den zweiten Anschluss des zweiten Kondensators (C2), wobei die erste Referenzspannung (V_{Bi}) für den ersten digitalen Wert *(Bi)* repräsentativ ist, der erste Kondensator (C1) zwischen dem ersten Eingangsanschluss und dem Ausgangsanschluss des Verstärkers (7) geschaltet ist, wobei der erste Schalter (T1) im Sperrzustand ist und die zweiten Anschlüsse des zweiten und dritten Kondensators (C3, C4) auf einem schwebenden Potenzial liegen,
- Berechnen einer ersten Zwischenspannung (V1) mittels des Verstärkers (7) und des ersten und zweiten Kondensators (C1, C2) unter Verwendung der umzuwandelnden Spannung (Vin) und der ersten Referenzspannung (V_{Bi}) während der zweiten Periode,
- Vergleichen der ersten Zwischenspannung (V1) mit einer zweiten Vergleichsspannung (Vref2) durch einen zweiten Komparator (5) und Ausgeben eines zweiten digitalen Werts (*B*_{*i*+1}) mit mindestens einem zweiten Bit, wobei der erste Kondensator (C1) zwischen dem ersten Eingangsanschluss und dem Ausgangsanschluss des Verstärkers (7) geschaltet ist und der erste Schalter (T1) im Sperrzustand ist,
- während einer dritten Periode, Anlegen der ersten Referenzspannung (V_{Bi}) an die zweite Elektrode des dritten Kondensators (C3) und Anlegen einer zweiten Referenzspannung (V_{Bi+1}) an den zweiten Anschluss des vierten Kondensators (C4), wobei die zweite Referenzspannung (V_{Bi+1}) für den zweiten digitalen Wert ( *B*_{*i*+1}) repräsentativ ist, der erste Kondensator (C1) zwischen dem ersten Eingangsanschluss und dem Ausgangsanschluss des Verstärkers (7) geschaltet ist, der erste Schalter (T1) im Sperrzustand ist und die erste Referenzspannung (V_{Bi}) an den zweiten Anschluss des zweiten Kondensators (C2) angelegt wird,
- Berechnen einer zweiten Zwischenspannung (V2) mittels des Verstärkers (7) und des ersten, zweiten, dritten und vierten Kondensators (C1, C2, C3, C4) unter Verwendung der umzuwandelnden Spannung (Vin), der ersten Referenzspannung (V_{Bi}) und der zweiten Referenzspannung (V_{Bi+1}) während der dritten Periode.

## Claims

1. Analog-to-digital converter comprising:
- an input terminal receiving a voltage to be converted (Vin), the voltage to be converted being comprised in a conversion range bounded by a first voltage (Va) and a second voltage (Vb),
- an amplifier (7) having a first input terminal and an output terminal forming an analog output terminal of the converter,
- a first switch (T1) connecting the input terminal of the amplifier (7) and the output terminal of the amplifier (7),
- first, second, third and fourth capacitors (C1, C2, C3, C4) having a first terminal connected to the first input terminal of the amplifier (7),
- a second switch (T2) connecting a second terminal of the first capacitor (C1) to the output terminal of the amplifier (7),
- a first comparator (2) receiving the voltage to be converted (Vin) and at least one first comparison voltage (Vref1) and configured to perform comparison between the voltage to be converted (Vin) and the at least one first comparison voltage (Vref1), and to deliver, on a first digital output, a first digital value *(Bi)* on at least a first bit representative of said comparison,
- a second comparator (5) receiving a first intermediate voltage (V1) and at least a second comparison voltage (Vref2) and configured to perform comparison between the first intermediate voltage (V1) and the at least one second comparison voltage (Vref2), and to deliver, on a second digital output, a second digital value (*B*_{*i*+1}) on at least a second bit representative of said comparison,
- a voltage source (8) comprising (i) a group of first switches (T1) connecting a generator of the voltage to be converted (Vin) to the second terminals of the first, second, third and fourth capacitors (C4), the first switches (T1) having a control electrode connected to a generator of a first signal (S1), (ii) a group of second switches (T2) connecting a generator of the first reference voltage (V_{Bi}) to the second terminal of the second capacitor (C2), the second switches (T2) having a control electrode connected to a generator of a second signal (S2), (iii) a group of third switches (T3) connecting the generator of the first reference voltage (V_{Bi}) to the second terminal of the third capacitor (C3) and connecting a generator of the second reference voltage (V_{Bi+1}) to the second terminal of the fourth capacitor (C4), the third switches (T3) having a control electrode connected to a generator of a third signal (S3), the voltage source (8) being configured to:
∘ apply the voltage to be converted (Vin) on a second terminal of the first, second, third and fourth capacitors (C1, C2, C3, C4) during a first period, the group of first switches (T1) being in the passing state during the first period and in the blocking state during second and third periods,
∘ apply a first reference voltage (V_{Bi}) on the second terminal of the second capacitor (C2) during the second and third periods, the first reference voltage (Vei) being representative of the first digital value (*Bi*), the group of second switches (T2) being in the passing state during the second and third periods and in the blocking state during the first period,
∘ apply the first reference voltage (V_{Bi}) on the second terminal of the third capacitor (C3) during the third period, and apply a second reference voltage (V_{Bi+1}) on the second terminal of the fourth capacitor (C4) during the third period, the second reference voltage (V_{Bi+1}) being representative of the second digital value (*B*_{*i*+1}), the group of third switches (T3) being in the passing state during the third period and in the blocking state during the first and second periods,
- a control circuit configured to calculate, by means of the amplifier (7) and the second switch (T2),
∘ the first intermediate voltage (V1) from the voltage to be converted (Vin), from the first digital value *(Bi)* and from said first voltage (Va) and second voltage (Vb),
∘ a second intermediate voltage (V2) from the voltage to be converted (Vin), from the first and second digital values (*Bi, B*_{*i*+1}) and from said first voltage (Va) and second voltage (Vb),
the control circuit being configured so that the second switch (T2) is in the blocking state during the first period and in the passing state during the second period and the third period.

2. Converter according to claim 1, **characterized in that** the first comparator (2) and the second comparator (5) are formed by a same comparator and **in that** it comprises a selector switch configured to connect the input terminal of the comparator (2, 5) to the output terminal of the amplifier (7) or to the input terminal receiving the voltage to be converted (Vin).

3. Converter according to any one of claims 1 and 2, **characterized in that** the value of the first reference voltage (V_{Bi}) depends solely on the first digital value (*Bi*)*.*

4. Converter according to any one of claims 1 to 3, **characterized in that** the value of the second reference voltage (V_{Bi+1}) depends solely on the second digital value (*B*_{*i*+1}).

5. Converter according to any one of the foregoing claims, **characterized in that** the residual voltage (V2) is representative of 4Vin - (Va+Vb) + *Bi*.(Va-Vb) +*B̅i*.(Vb-Va) - (Va+Vb)/2 + *B*_{*i*+1}.(Va-Vb)/2 + *B̅*_{*i*+1}.(Vb-Va)/2.

6. Converter according to one of 1 and 2, **characterized in that** the first comparator (2) is formed by two comparators (2a, 2b) on one bit delivering a first digital value defined by first and second elementary bits (*Bi*⁻, *Bi*⁺)*.*

7. Converter according to one of the foregoing claims, **characterized in that** the second comparator (5) is formed by two comparators (2a, 2b) on one bit delivering a second digital value defined by third and fourth elementary bits (*B*_{*i*+1}⁻ , *B*_{*i*+1}⁺).

8. Converter according to claim 7, **characterized in that** the second intermediate voltage (V2) is representative of 4Vin - 2(*Bi*⁻ AND *Bi*⁺).Vref⁺ - 2(*Bi*⁻ OR *Bi*⁺ ).(Va+Vb)/2 - 2(*B̅i̅⁻̅* AND *̅B̅i̅*̅⁺̅).Vref- - (*B*_{*i*+1}*⁻* AND *B*_{*i*+1}⁺).Vref⁺ - (*B*_{*i*+1}*⁻* OR *B*ᵢ₊₁⁺ ).(Va+Vb)/2 - (*̅B̅*̅_̅{̅*̅i̅*̅+̅1̅}̅⁻̅ AND *̅B̅*̅ᵢ̅₊̅₁̅⁺̅).Vref⁻.

9. Converter according to any one of the foregoing claims, **characterized in that** it comprises first and second additional capacitors, the first and second additional capacitors (C1', C2') having a first terminal connected to the first input terminal of the amplifier (7), the second terminal of the first additional capacitor (C1') being connected to the output of the amplifier (7) by means of a third switch (T3) of the group of third switches (T3), the second terminal of the second additional capacitor (C2') is connected to receive the first reference voltage (V_{Bi}) via a third switch (T3) of the group of third switches (T3).

10. Converter according to any one of the foregoing claims, **characterized in that** the first switch (T1) is configured to directly connect the input terminal of the amplifier (7) and the output terminal of the amplifier (7).

11. Operating method of an analog-to-digital converter comprising:
- providing an analog-to-digital converter comprising
∘ an amplifier (7) having a first input terminal and an output terminal forming an analog output terminal of the converter,
∘ a first switch (T1) connecting the input terminal of the amplifier (7) and the output terminal of the amplifier (7),
∘ first, second, third and fourth capacitors (C1, C2, C3, C4) having a first terminal connected to the first input terminal of the amplifier (7),
- sampling a voltage to be converted (Vin) during a first period by applying said voltage to be converted to second terminals of the first, second, third and fourth capacitors (C1, C2, C3, C4), the voltage to be converted being comprised in a conversion range bounded by a first voltage (Va) and second voltage (Vb), the amplifier being connected as a follower by means of the first switch (T1),
- comparing the voltage to be converted (Vin) with a first comparison voltage (Vref1) by means of a first comparator (2) and delivering a first digital value *(Bi)* on at least a first bit,
- during a second period, applying a first reference voltage (V_{Bi}) on the second terminal of the second capacitor (C2), the first reference voltage (V_{Bi}) being representative of the first digital value *(Bi),* the first capacitor (C1) being connected between the first input terminal and the output terminal of the amplifier (7), the first switch (T1) being in the blocking state, the second terminals of the second and third capacitors (C3, C4) being at a floating potential,
- calculating a first intermediate voltage (V1) by means of the amplifier (7) and the first and second capacitors (C1, C2), from the voltage to be converted (Vin) and the first reference voltage (V_{Bi}), during the second period,
- comparing the first intermediate voltage (V1) with a second comparison voltage (Vref2) by means of a second comparator (5) and delivering a second digital value (*B*_{*i*+1}) on at least a second bit, the first capacitor (C1) being connected between the first input terminal and the output terminal of the amplifier (7), the first switch (T1) being in the blocking state,
- during a third period, applying the first reference voltage (V_{Bi}) on the second electrode of the third capacitor (C3) and applying a second reference voltage (V_{Bi+1}) on the second terminal of the fourth capacitor (C4), the second reference voltage (V_{Bi+1}) being representative of the second digital value (*B*_{*i*+1}), the first capacitor (C1) being connected between the first input terminal and the output terminal of the amplifier (7), the first switch (T1) being in the blocking state, the first reference voltage (Vei) being applied to the second terminal of the second capacitor (C2),
- calculating a second intermediate voltage (V2) by means of the amplifier (7) and the first, second, third and fourth capacitors (C1, C2, C3, C4), from the voltage to be converted (Vin), the first reference voltage (V_{Bi}) and the second reference voltage (V_{Bi+1}), during the third period.
